# EUROPEAN PATENT SPECIFICATION

(11) **EP 2 603 935 B1**
(45) Date of publication and mention of the grant of the patent: **10.10.2018**
(21) Application number: 11816999.4
(22) Date of filing: 10.08.2011
(51) Int. Cl.: H01L 33/00

(54) **QUANTUM DOT BASED LIGHTING**
QUANTENPUNKT-BASIERTE BELEUCHTUNG
ECLAIRAGE BASÉ SUR DES BOÎTES QUANTIQUES

(30) Priority: 11.08.2010 US 372811 P
(43) Date of publication of application: 19.06.2013
(73) Proprietor: Samsung Electronics Co., Ltd., Suwon-si, Gyeonggi-do (KR)
(72) Inventor: SADASIVAN, Sridhar, Somerville MA 02143 (US); LINTON, John, R., Concord MA 01742 (US); GILDEA, David, R., Watertown MA 02472 (US); COE-SULLIVAN, Seth, Redondo Beach CA 90278 (US); SHAH, Suchit, Waltham MA 02452 (US); NICK, Robert, J., Pepperell MA 01463 (US)
(74) Representative: Portch, Daniel
(86) International application number: PCT/US2011/047284
(87) International publication number: WO 2012/021643

(56) References cited:
- WO-A1-2008/063866
- WO-A1-2010/056240
- US-A1- 2004 145 289
- US-A1- 2005 111 805
- US-A1- 2006 160 162
- US-A1- 2006 255 713
- US-A1- 2008 173 886
- US-A1- 2008 173 886
- US-A1- 2010 079 061
- US-A1- 2010 155 749
- US-A1- 2010 155 749
- US-A1- 2010 193 806
- US-B1- 7 544 323

## Description

### FIELD OF THE DISCLOSURE

Embodiments of the present disclosure relate to the generation of light using quantum dots (including, but not limited to, semiconductor nanocrystals), and their use in structures for lighting applications and optical display systems.

### BACKGROUND OF THE DISCLOSURE

Liquid crystal displays (LCDs) are the dominant flat panel display technology in today's market. Conventional LCD systems include a network of optical components in front of a light source (e.g., fluorescent lamps, light emitting diodes (LEDs), etc.) commonly referred to as a backlight unit. Conventional backlight units include a light source coupled to a light guide through which the light travels eventually to a display panel. LED backlights employed in conventional systems include a set of optical films placed on top of an LED source, a slight distance away from the source. Among other things, the selection of a proper distance between the LED source and the associated optical films ensures that the light entering the display panel is properly optimized.

The quality of an LCD is often measured by a color gamut diagram. The color gamut refers to the total space of colors that may be represented by a display. Generally, the color gamut is shown by diagrams such as the International Commission on Illumination (CIE) 1931 XY color diagram. In this diagram, the gamut of available colors is represented by chromaticity on the x axis and brightness or luminance on the y axis. The gamut of all visible colors on a 2-D CIE plot is generally represented by a tongue shaped area in the center of the diagram.

Increasing the color gamut of a display device increases color quality and also leads to a higher perceived brightness. This effect is known as the Helmholtz- Kohlrauch (H-K) effect, which is defined as "Change in brightness of a perceived color produced by increasing the purity of a color stimulus while keeping its luminance constant within the range of photopic vision." (See CIE Publication No. 17.4, International Lighting Vocabulary, Central Bureau of CIE, Vienna, 1988, sec. 845-02- 34, p.50.) This effect is dependent on ambient lighting conditions (i.e., the effect is enhanced under lower ambient lighting conditions and is diminished under higher ambient lighting conditions).

Two different LED light sources have been utilized in LCDs: (1) the combination of red, green and blue (RGB) LEDs and (2) white LEDs. Compared to the use of white LEDs, the use of RGB LEDs allows for a better color gamut but also adds significant complexity in implementation. The reduced complexity and, therefore reduced cost, of white LED backlights has caused these structures to be the implementation of choice in commercial LCD displays. Thus, some conventional displays have only a 70% color gamut (relative to the 1953 NTSC standard). In addition, some conventional LED sources require numerous color filters in the optical stack which increases power consumption.

Accordingly, one object of the present invention is to increase performance of display systems such as by increasing the color gamut and/or lowering power consumption while still maintaining ease of implementation thus resulting in lower costs.

Document US 2008/0173886 discloses solid state lighting devices containing quantum dots dispersed in polymeric or silicone acrylates and deposited over a light source.

Document WO 2008/063866 discloses a device for stimulable light emission that includes a fiber mat of nanofibres and includes plural stimulable particles disposed in association with the nanofibres. The stimulable particles produce secondary light emission upon receiving primary light at a first wavelength.

### BRIEF SUMMARY OF THE DISCLOSURE

The invention is defined by the claims.

The following presents a simplified summary in order to provide a basic understanding of some aspects of the disclosure. This summary is not an extensive overview of the disclosure. It is not intended to identify key or critical elements of the disclosure or to delineate the scope of the disclosure. The following summary merely presents some concepts of the disclosure in a simplified form as a prelude to the more detailed description provided below.

Embodiments of the present disclosure are directed to various backlight unit apparatus designs including various couplings of quantum dot-containing devices to light guides for the efficient transfer of the generated light to and through the light guide. According to certain aspects, methods and devices are provided for the illumination and stimulation of quantum dots and the efficient coupling or directing of resultant radiation to and through a light guide. Embodiments are further provided for a backlight unit including quantum dots positioned within, and component to, an LED. Such an LED of the present invention utilizes quantum dots to increase color gamut and generate perceived brightness.

In accordance with a particular aspect of the invention, there is provided a backlight unit apparatus for generating white light comprising: a light source capable of emitting blue light; an optical material comprising a host material and a first quantum dots capable of emitting green light and second quantum dots capable of emitting red light, wherein the weight percentage ratio of the first quantum dots to the second quantum dots in the optical material is in a range from 9:1 to 2:1, wherein the light source is positioned to be capable of illuminating the optical material and wherein the optical material is positioned adjacent to an edge surface of a transparent light guide; and characterised in that the backlight unit further comprises an optic comprising a transparent capillary comprising the optical material, wherein a light reflective material partially surrounds the capillary.

The present disclosure further describes an optical material including quantum dots (including, e.g., semiconductor nanocrystals) to generate light. According to one aspect, a combination of certain quantum dots of the present invention, such as quantum dots that emit green light wavelengths and quantum dots that emit red light wavelengths, that are stimulated by an LED emitting blue light wavelengths results in the generation of trichromatic white light. According to certain aspects, light generated by quantum dots, such as trichromatic white light, is used in combination with a liquid crystal display (LCD) unit or other optical display unit. On implementation of the present invention is a combination of the quantum dots, an LED blue light source and a light guide for use as a backlight unit which can be further used, for example, with an LCD unit.

The present disclosure further describes mixtures or combinations or ratios of quantum dots that are used to achieve certain desired radiation output. Such quantum dots can emit red and green light of certain wavelength when exposed to a suitable stimulus. Still further embodiments are directed to various formulations including quantum dots which are used in various light emitting applications. (Formulations including quantum dots may also be referred to herein as "quantum dot formulations" or "optical materials".) For example, quantum dot formulations can take the form of flowable fluids, commonly known as quantum dot inks. If used as a flowable fluid, methods are provided herein for transferring the flowable fluid into a suitable receptacle, such as a capillary tube, which is used in combination with a light guide, for example.

Quantum dot formulations can also be included in, or otherwise form, physical structures. Quantum dot formulations can include, for example, monomers which can be polymerized into desired physical structures, such as films. Accordingly, methods for making quantum dot films are provided herein.

The foregoing, and other aspects and embodiments described herein all constitute embodiments of the present invention.

It should be appreciated by those persons having ordinary skill in the art(s) to which the present invention relates that any of the features described herein in respect of any particular aspect and/or embodiment of the present invention can be combined with one or more of any of the other features of any other aspects and/or embodiments of the present invention described herein, with modifications as appropriate to ensure compatibility of the combinations. Such combinations are considered to be part of the present invention contemplated by this disclosure.

It is to be understood that both the foregoing general description and the following detailed description are exemplary and explanatory only and are not restrictive of the invention as claimed. Other embodiments will be apparent to those skilled in the art from consideration of the specification and practice of the invention disclosed herein.

### BRIEF DESCRIPTION OF THE DRAWINGS

The foregoing and other features and advantages of the present disclosure will be more fully understood from the following detailed description of illustrative embodiments taken in conjunction with the accompanying drawings in which:
Figure 1A illustrates an example of a method for filling capillaries with quantum dot-containing ink in accordance with various aspects of the disclosure.
Figure 1B illustrates an example of a method for filling capillaries with quantum dot containing ink in accordance with various aspects of the disclosure.
Figure 2 illustrates the spectra of an embodiment of a quantum dot containing backlight unit (BLU) and a white LED BLU.
Figure 3 illustrates an example of a capillary in accordance with various aspects of the disclosure.
Figure 4 illustrates an example of a capillary in accordance with various aspects of the disclosure.
Figure 5 illustrates an example of a capillary in accordance with various aspects of the disclosure.
Figure 6 illustrates an example of a quantum dot containing backlight created by integrating an LED source with a film including quantum dots in accordance with various aspects of the disclosure.
Figure 7a illustrates the insertion of a thin capillary optic containing quantum dots between LEDs and a light guide in accordance with various aspects of the disclosure.
Figure 7b illustrates the insertion of a film including quantum dots into the optical film stack in accordance with various aspects of the disclosure.
Figure 8 illustrates the use of a reflective material or film around a capillary to allow light from an LED to pass into the capillary and to guide light from the capillary into a light guide in accordance with various aspects of the disclosure.
Figure 9 illustrates the use of a short band pass filter deposited on three sides of a capillary to pass LED light but reflect quantum dot-generated light into the light guide in accordance with various aspects of the disclosure.

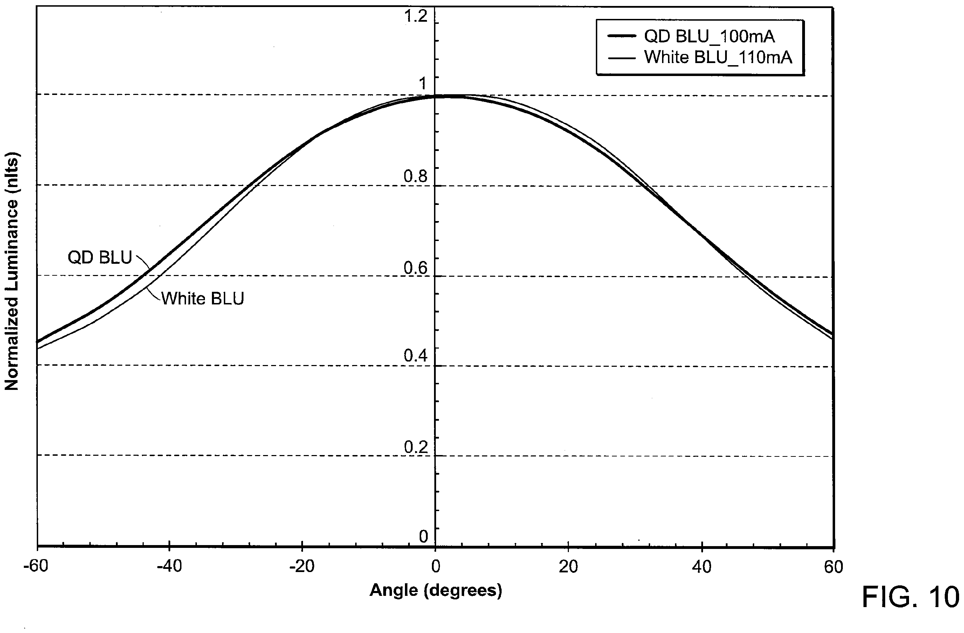

Figure 10 illustrates that the luminance profile of a quantum dot-containing BLU stack (including red and green quantum dots excited by an LED emitting blue light) matches the luminance profile of a conventional white BLU stack in accordance with various aspects of the disclosure.
Figure 11 illustrates the change in quantum efficiency of a quantum dot- containing optic BLU as a function of time when a quantum dot optic including red quantum dots and green quantum dots is exposed to high energy blue LED light (∼25 mW/cm²) and temperatures of up to 80°C accordance with various aspects of the disclosure.
Figure 12 depicts the spectral profile of tri-chromatic white light coming from examples of backlight units described herein that include red-emitting quantum dots with emissions at different peak center wavelengths (630 nm, 620 nm, and 615 nm).
Figure 13 illustrates an optical film stack with an edge optic in accordance with various aspects of the disclosure.

### DETAILED DESCRIPTION OF THE DISCLOSURE

Embodiments of the present disclosure are directed to the use of quantum dots in combination with a stimulating light to produce trichromatic white light. The trichromatic white light is used in various lighting applications such as backlight units for liquid crystal displays.

Quantum dots are nanometer sized particles that can have optical properties arising from quantum confinement. Quantum dots can emit light when subjected to a stimulating radiation.

The particular composition(s), structure, and/or size of a quantum dot can be selected to achieve the desired wavelength of light to be emitted from the quantum dot upon stimulation with a particular excitation source. In essence, quantum dots may be tuned to emit light across the visible spectrum by changing their size. See C.B. Murray, C.R. Kagan, and M.G. Bawendi, Annual Review of Material Sci., 2000, 30: 545-610 .

Quantum dots can have an average particle size in a range from about 1 to about 1000 nanometers (nm), and preferably in a range from about 1 to about 100 nm. In certain embodiments, quantum dots have an average particle size in a range from about 1 to about 20 nm (e.g., such as about 5, 6, 7, 8, 9, 10, 11, 12, 13, 14, 15, 16, 17, 18, 19, or 20 nm). In certain embodiments, quantum dots have an average particle size in a range from about 1 to about 10 nm. Quantum dots can have an average diameter less than about 150 Angstroms (Å). In certain embodiments, quantum dots having an average diameter in a range from about 12 to about 150 Å can be particularly desirable. However, depending upon the composition, structure, and desired emission wavelength of the quantum dot, the average diameter may be outside of these ranges.

Preferably, a quantum dot comprises a semiconductor nanocrystal. In certain embodiments, a semiconductor nanocrystal has an average particle size in a range from about 1 to about 20 nm, and preferably from about 1 to about 10 nm. However, depending upon the composition, structure, and desired emission wavelength of the quantum dot, the average diameter may be outside of these ranges.

A quantum dot can comprise one or more semiconductor materials.

Examples of semiconductor materials that can be included in a quantum dot (including, e.g., semiconductor nanocrystal) include, but are not limited to, a Group IV element, a Group II-VI compound, a Group II-V compound, a Group III-VI compound, a Group III-V compound, a Group IV-VI compound, a Group I-III-VI compound, a Group II-IV-VI compound, a

Group II-IV-V compound, an alloy including any of the foregoing, and/or a mixture including any of the foregoing, including ternary and quaternary mixtures or alloys. A non-limiting list of examples include ZnO, ZnS, ZnSe, ZnTe, CdO, CdS, CdSe, CdTe, MgS, MgSe, GaAs, GaN, GaP, GaSe, GaSb, HgO, HgS, HgSe, HgTe, InAs, InN, InP, InSb, AlAs, AlN, AlP, AlSb, TIN, TIP, TIAs, TISb, PbO, PbS, PbSe, PbTe, Ge, Si, an alloy including any of the foregoing, and/or a mixture including any of the foregoing, including ternary and quaternary mixtures or alloys.

In certain embodiments, quantum dots can comprise a core comprising one or more semiconductor materials and a shell comprising one or more semiconductor materials, wherein the shell is disposed over at least a portion, and preferably all, of the outer surface of the core. A quantum dot including a core and shell is also referred to as a "core/shell" structure.

For example, a quantum dot can include a core having the formula MX, where M is cadmium, zinc, magnesium, mercury, aluminum, gallium, indium, thallium, or mixtures thereof, and X is oxygen, sulfur, selenium, tellurium, nitrogen, phosphorus, arsenic, antimony, or mixtures thereof. Examples of materials suitable for use as quantum dot cores include, but are not limited to, ZnO, ZnS, ZnSe, ZnTe, CdO, CdS, CdSe, CdTe, MgS, MgSe, GaAs, GaN, GaP, GaSe, GaSb, HgO, HgS, HgSe, HgTe, InAs, InN, InP, InSb, AlAs, AlN, AlP, AlSb, TIN, TIP, TIAs, TISb, PbO, PbS, PbSe, PbTe, Ge, Si, an alloy including any of the foregoing, and/or a mixture including any of the foregoing, including ternary and quaternary mixtures or alloys.

A shell can be a semiconductor material having a composition that is the same as or different from the composition of the core. The shell can comprise an overcoat including one or more semiconductor materials on a surface of the core. Examples of semiconductor materials that can be included in a shell include, but are not limited to, a Group IV element, a Group II-VI compound, a Group II-V compound, a Group III-VI compound, a Group III-V compound, a Group IV-VI compound, a Group I-III-VI compound, a Group II-IV-VI compound, a Group II-IV-V compound, alloys including any of the foregoing, and/or mixtures including any of the foregoing, including ternary and quaternary mixtures or alloys. Examples include, but are not limited to, ZnO, ZnS, ZnSe, ZnTe, CdO, CdS, CdSe, CdTe, MgS, MgSe, GaAs, GaN, GaP, GaSe, GaSb, HgO, HgS, HgSe, HgTe, InAs, InN, InP, InSb, AlAs, AlN, AlP, AlSb, TIN, TIP, TIAs, TISb, PbO, PbS, PbSe, PbTe, Ge, Si, an alloy including any of the foregoing, and/or a mixture including any of the foregoing. For example, ZnS, ZnSe or CdS overcoatings can be grown on CdSe or CdTe semiconductor nanocrystals.

In a core/shell quantum dot, the shell or overcoating may comprise one or more layers. The overcoating can comprise at least one semiconductor material which is the same as or different from the composition of the core. Preferably, the overcoating has a thickness from about one to about ten monolayers. An overcoating can also have a thickness greater than ten monolayers. In certain embodiments, more than one overcoating can be included on a core.

In certain embodiments, the surrounding "shell" material can have a band gap greater than the band gap of the core material. In certain other embodiments, the surrounding shell material can have a band gap less than the band gap of the core material.

In certain embodiments, the shell can be chosen so as to have an atomic spacing close to that of the "core" substrate. In certain other embodiments, the shell and core materials can have the same crystal structure.

Examples of quantum dot (e.g., semiconductor nanocrystal) (core)shell materials include, without limitation: red (e.g., (CdSe)CdZnS (core)shell), green (e.g., (CdZnSe)CdZnS (core)shell, etc.), and blue (e.g., (CdS)CdZnS (core)shell.

Quantum dots can have various shapes, including, but not limited to, sphere, rod, disk, other shapes, and mixtures of various shaped particles.

One example of a method of manufacturing a quantum dot (including, for example, but not limited to, a semiconductor nanocrystal) is a colloidal growth process. Colloidal growth occurs by injection an M donor and an X donor into a hot coordinating solvent. One example of a preferred method for preparing monodisperse quantum dots comprises pyrolysis of organometallic reagents, such as dimethyl cadmium, injected into a hot, coordinating solvent. This permits discrete nucleation and results in the controlled growth of macroscopic quantities of quantum dots. The injection produces a nucleus that can be grown in a controlled manner to form a quantum dot. The reaction mixture can be gently heated to grow and anneal the quantum dot. Both the average size and the size distribution of the quantum dots in a sample are dependent on the growth temperature. The growth temperature for maintaining steady growth increases with increasing average crystal size. Resulting quantum dots are members of a population of quantum dots. As a result of the discrete nucleation and controlled growth, the population of quantum dots that can be obtained has a narrow, monodisperse distribution of diameters. The monodisperse distribution of diameters can also be referred to as a size. Preferably, a monodisperse population of particles includes a population of particles wherein at least about 60% of the particles in the population fall within a specified particle size range. A population of monodisperse particles preferably deviate less than 15% rms (root-mean-square) in diameter and more preferably less than 10% rms and most preferably less than 5%.

An example of an overcoating process is described, for example, in U.S. Patent 6,322,901. By adjusting the temperature of the reaction mixture during overcoating and monitoring the absorption spectrum of the core, overcoated materials having high emission quantum efficiencies and narrow size distributions can be obtained.

The narrow size distribution of the quantum dots (including, e.g., semiconductor nanocrystals) allows the possibility of light emission in narrow spectral widths. Monodisperse semiconductor nanocrystals have been described in detail in Murray et al. (J. Am. Chem. Soc, 115:8706 (1993)); in the thesis of Christopher Murray, and "Synthesis and Characterization of II-VI Quantum Dots and Their Assembly into 3-D Quantum Dot Superlattices", Massachusetts Institute of Technology, September, 1995.

The process of controlled growth and annealing of the quantum dots in the coordinating solvent that follows nucleation can also result in uniform surface derivatization and regular core structures. As the size distribution sharpens, the temperature can be raised to maintain steady growth. By adding more M donor or X donor, the growth period can be shortened. The M donor can be an inorganic compound, an organometallic compound, or elemental metal. For example, an M donor can comprise cadmium, zinc, magnesium, mercury, aluminum, gallium, indium or thallium, and the X donor can comprise a compound capable of reacting with the M donor to form a material with the general formula MX. The X donor can comprise a chalcogenide donor or a pnictide donor, such as a phosphine chalcogenide, a bis(silyl) chalcogenide, dioxygen, an ammonium salt, or a tris(silyl) pnictide. Suitable X donors include, for example, but are not limited to, dioxygen, bis(trimethylsilyl) selenide ((TMS)₂Se), trialkyl phosphine selenides such as (tri-noctylphosphine) selenide (TOPSe) or (tri-n-butylphosphine) selenide (TBPSe), trialkyl phosphine tellurides such as (tri-n-octylphosphine) telluride (TOPTe) or hexapropylphosphorustriamide telluride (HPPTTe), bis(trimethylsilyl)telluride ((TMS)₂Te), bis(trimethylsilyl)sulfide ((TMS)₂S), a trialkyl phosphine sulfide such as (tri-noctylphosphine) sulfide (TOPS), an ammonium salt such as an ammonium halide (e.g., NH₄Cl), tris(trimethylsilyl) phosphide ((TMS)₃P), tris(trimethylsilyl) arsenide ((TMS)₃As), or tris(trimethylsilyl) antimonide ((TMS)₃Sb). In certain embodiments, the M donor and the X donor can be moieties within the same molecule.

A coordinating solvent can help control the growth of the quantum dot. A coordinating solvent is a compound having a donor lone pair that, for example, a lone electron pair available to coordinate to a surface of the growing quantum dot (including, e.g., a semiconductor nanocrystal). Solvent coordination can stabilize the growing quantum dot. Examples of coordinating solvents include alkyl phosphines, alkyl phosphine oxides, alkyl phosphonic acids, or alkyl phosphinic acids, however, other coordinating solvents, such as pyridines, furans, and amines may also be suitable for the quantum dot (e.g., semiconductor nanocrystal) production. Additional examples of suitable coordinating solvents include pyridine, tri-n-octyl phosphine (TOP), tri-n-octyl phosphine oxide (TOPO) and trishydroxylpropylphosphine (tHPP), tributylphosphine, tri(dodecyl)phosphine, dibutyl-phosphite, tributyl phosphite, trioctadecyl phosphite, trilauryl phosphite, tris(tridecyl) phosphite, triisodecyl phosphite, bis(2-ethylhexyl)phosphate, tris(tridecyl) phosphate, hexadecylamine, oleylamine, octadecylamine, bis(2-ethylhexyl)amine, octylamine, dioctylamine, trioctylamine, dodecylamine/laurylamine, didodecylamine tridodecylamine, hexadecylamine, dioctadecylamine, trioctadecylamine, phenylphosphonic acid, hexylphosphonic acid, tetradecylphosphonic acid, octylphosphonic acid, octadecylphosphonic acid, propylenediphosphonic acid, phenylphosphonic acid, aminohexylphosphonic acid, dioctyl ether, diphenyl ether, methyl myristate, octyl octanoate, and hexyl octanoate. In certain embodiments, technical grade TOPO can be used.

In certain embodiments, quantum dots can alternatively be prepared with use of non-coordinating solvent(s).

Size distribution during the growth stage of the reaction can be estimated by monitoring the absorption or emission line widths of the particles. Modification of the reaction temperature in response to changes in the absorption spectrum of the particles allows the maintenance of a sharp particle size distribution during growth. Reactants can be added to the nucleation solution during crystal growth to grow larger crystals. For example, for CdSe and CdTe, by stopping growth at a particular semiconductor nanocrystal average diameter and choosing the proper composition of the semiconducting material, the emission spectra of the semiconductor nanocrystals can be tuned continuously over the wavelength range of 300 nm to 5 micrometers, or from 400 nm to 800 nm.

The particle size distribution of the quantum dots (including, e.g., semiconductor nanocrystals) can be further refined by size selective precipitation with a poor solvent for the quantum dots, such as methanol butanol. For example, quantum dots can be dispersed in a solution of 10% butanol in hexane. Methanol can be added dropwise to this stirring solution until opalescence persists. Separation of supernatant and flocculate by centrifugation produces a precipitate enriched with the largest crystallites in the sample. This procedure can be repeated until no further sharpening of the optical absorption spectrum is noted. Size-selective precipitation can be carried out in a variety of solvent/nonsolvent pairs, including pyridine/hexane and chloroform/methanol. The size-selected quantum dot (e.g., semiconductor nanocrystal) population preferably has no more than a 15% rms deviation from mean diameter, more preferably 10% rms deviation or less, and most preferably 5% rms deviation or less.

Semiconductor nanocrystals and other types of quantum dots preferably have ligands attached thereto.

Ligands can be derived from a coordinating solvent that may be included in the reaction mixture during the growth process.

Ligands can be added to the reaction mixture.

Ligands can be derived from a reagent or precursor included in the reaction mixture for synthesizing the quantum dots.

In certain embodiments, quantum dots can include more than one type of ligand attached to an outer surface.

A quantum dot surface that includes ligands derived from the growth process or otherwise can be modified by repeated exposure to an excess of a competing ligand group (including, e.g., but not limited to, coordinating group) to form an overlayer. For example, a dispersion of the capped quantum dots can be treated with a coordinating organic compound, such as pyridine, to produce crystallites which disperse readily in pyridine, methanol, and aromatics but no longer disperse in aliphatic solvents. Such a surface exchange process can be carried out with any compound capable of coordinating to or bonding with the outer surface of the nanoparticle, including, for example, but not limited to, phosphines, thiols, amines and phosphates.

For example, a quantum dot can be exposed to short chain polymers which exhibit an affinity for the surface and which terminate in a moiety having an affinity for a suspension or dispersion medium. Such affinity improves the stability of the suspension and discourages flocculation of the quantum dot. Examples of additional ligands include alkyl phosphines, alkyl phosphine oxides, alkyl phosphonic acids, or alkyl phosphinic acids, pyridines, furans, and amines. More specific examples include, but are not limited to, pyridine, tri-n-octyl phosphine (TOP), tri-n-octyl phosphine oxide (TOPO) and tris-hydroxylpropylphosphine (tHPP). Technical grade TOPO can be used.

Suitable coordinating ligands can be purchased commercially or prepared by ordinary synthetic organic techniques, for example, as described in J. March, Advanced Organic Chemistry, which is incorporated herein by reference in its entirety.

The emission from a quantum dot capable of emitting light can be a narrow Gaussian emission band that can be tuned through the complete wavelength range of the ultraviolet, visible, or infra-red regions of the spectrum by varying the size of the quantum dot, the composition of the quantum dot, or both. For example, a semiconductor nanocrystal comprising CdSe can be tuned in the visible region; a semiconductor nanocrystal comprising InAs can be tuned in the infra-red region. The narrow size distribution of a population of quantum dots capable of emitting light can result in emission of light in a narrow spectral range. The population can be monodisperse preferably exhibits less than a 15% rms (root-mean-square) deviation in diameter of such quantum dots, more preferably less than 10%, most preferably less than 5%. Spectral emissions in a narrow range of no greater than about 75 nm, preferably no greater than about 60 nm, more preferably no greater than about 40 nm, and most preferably no greater than about 30 nm full width at half max (FWHM) for such quantum dots that emit in the visible can be observed. IR-emitting quantum dots can have a FWHM of no greater than 150 nm, or no greater than 100 nm. Expressed in terms of the energy of the emission, the emission can have a FWHM of no greater than 0.05 eV, or no greater than 0.03 eV. The breadth of the emission decreases as the dispersity of the light-emitting quantum dot diameters decreases.

Quantum dots can have emission quantum efficiencies such as greater than 10%, 20%, 30%, 40%, 50%, 60%, 70%, 80%, or 90%.

The narrow FWHM of quantum dots can result in saturated color emission. The broadly tunable, saturated color emission over the entire visible spectrum of a single material system is unmatched by any class of organic chromophores (see, for example, Dabbousi et al, J. Phys. Chem. 101, 9463 (1997), which is incorporated by reference in its entirety). A monodisperse population of quantum dots will emit light spanning a narrow range of wavelengths.

Useful quantum dots according to the present disclosure include those that emit wavelengths characteristic of red light. In certain preferred embodiments, quantum dots capable of emitting red light emit light having a peak center wavelength in a range from about 615 nm to about 630 nm, and any wavelength in between whether overlapping or not. For example, the quantum dots can be capable or emitting red light having a peak center wavelength of about 630 nm, of about 625 nm, of about 620 nm, of about 615 nm.

Useful quantum dots according to the present invention also include those that emit wavelength characteristic of green light. In certain preferred embodiments, quantum dots capable of emitting green light emit light having a peak center wavelength in a range from about 520 nm to about 540 nm, and any wavelength in between whether overlapping or not. For example, the quantum dots can be capable or emitting green light having a peak center wavelength of about 520 nm, of about 525 nm, of about 535 nm, of about 540 nm.

According to further aspects of the present invention, the quantum dots exhibit a narrow emission profile in the range of between about 25 nm and about 60 nm at full width half maximum (FWHM). The narrow emission profile of quantum dots of the present disclosure allows the tuning of the quantum dots and mixtures of quantum dots to emit saturated colors thereby increasing color gamut and power efficiency beyond that of conventional LED lighting displays. According to one aspect, green quantum dots designed to emit a predominant wavelength of, for example, about 523 nm and having an emission profile with a FWHM of about, for example, 37 nm are combined, mixed or otherwise used in combination with red quantum dots designed to emit a predominant wavelength of about, for example, 617 nm and having an emission profile with a FWHM of about, for example 32 nm. Such combinations can be stimulated by blue light to create trichromatic white light.

Quantum dots in accordance with the present invention can be included in various formulations depending upon the desired utility. According to one aspect, quantum dots are included in flowable formulations or liquids to be included, for example, into clear vessels which are to be exposed to light. Such formulations can include various amounts of one or more type of quantum dots and one or more host materials. Such formulations can further include one or more scatterers. Other optional additives or ingredients can also be included in a formulation. In certain embodiments, a formulation can further include one or more photo initiators. One of skill in the art will readily recognize from the present disclosure that additional ingredients can be included depending upon the particular intended application for the quantum dots.

An optical material or formulation within the scope of the disclosure may include a host material, which may be present in an amount from about 50 weight percent and about 99.5 weight percent, and any weight percent in between whether overlapping or not. In certain embodiment, a host material may be present in an amount from about 80 to about 99.5 weight percent. Examples of specific useful host materials include, but are not limited to, polymers, monomers, resins, binders, glasses, metal oxides, and other nonpolymeric materials. Preferred host materials include polymeric and non-polymeric materials that are at least partially transparent, and preferably fully transparent, to preselected wavelengths of light. In certain embodiments, the preselected wavelengths can include wavelengths of light in the visible (e.g., 400 - 700 nm) region of the electromagnetic spectrum. Preferred host materials include cross- linked polymers and solvent-cast polymers. Examples of other preferred host materials include, but are not limited to, glass or a transparent resin. In particular, a resin such as a non-curable resin, heat-curable resin, or photocurable resin is suitably used from the viewpoint of processability. Specific examples of such a resin, in the form of either an oligomer or a polymer, include, but are not limited to, a melamine resin, a phenol resin, an alkyl resin, an epoxy resin, a polyurethane resin, a maleic resin, a polyamide resin, polymethyl methacrylate, polyacrylate, polycarbonate, polyvinyl alcohol, polyvinylpyrrolidone, hydroxyethylcellulose, carboxymethylcellulose, and copolymers containing monomers forming these resins. Other suitable host materials can be identified by persons of ordinary skill in the relevant art.

Host materials can also comprise silicone materials. Suitable host materials comprising silicone materials can be identified by persons of ordinary skill in the relevant art.

In certain embodiments and aspects of the inventions contemplated by this disclosure, a host material comprises a photocurable resin. A photocurable resin may be a preferred host material in certain embodiments, e.g., in embodiments in which the composition is to be patterned. As a photocurable resin, a photo-polymerizable resin such as an acrylic acid or methacrylic acid based resin containing a reactive vinyl group, a photo-crosslinkable resin which generally contains a photo-sensitizer, such as polyvinyl cinnamate, benzophenone, or the like may be used. A heat-curable resin may be used when the photo-sensitizer is not used. These resins may be used individually or in combination of two or more.

In certain embodiments and aspects of the inventions contemplated by this disclosure, a host material can comprise a solvent-cast resin. A polymer such as a polyurethane resin, a maleic resin, a polyamide resin, polymethyl methacrylate, polyacrylate, polycarbonate, polyvinyl alcohol, polyvinylpyrrolidone, hydroxyethylcellulose, carboxymethylcellulose, and copolymers containing monomers forming these resins, can be dissolved in solvents known to those skilled in the art. Upon evaporation of the solvent, the resin forms a solid host material for the semiconductor nanoparticles.

In certain embodiments, acrylate monomers and/or acrylate oligomers which are commercially available from Radcure and Sartomer can be preferred.

Quantum dots can be encapsulated. Nonlimiting examples of encapsulation materials, related methods, and other information that may be useful are described in International Application No. PCT US2009/01372 of Linton, filed 4 March 2009 entitled "Particles Including Nanoparticles, Uses Thereof, And Methods" and U.S. Patent Application No. 61/240932 of Nick et al., filed 9 September 2009 entitled "Particles Including Nanoparticles, Uses Thereof, And Methods".

The total amount of quantum dots included in an optical material within the scope of the disclosure is preferably in a range from about 0.1 weight percent to about 10 weight percent, and any weight percent in between whether overlapping or not. The amount of quantum dots included in an optical material can vary within such range depending upon the application and the form in which the quantum dots are included (e.g., film, optics (e.g., capillary), encapsulated film, etc.), which can be chosen based on the particular end application. For instance, when an optic material is used in a thicker capillary with a longer pathlength (e.g., such as in BLUs for large screen television applications), the concentration of quantum dots can be closer to 0.5%. When an optical material is used in a thinner capillary with a shorter pathlength (e.g., such as in BLUs for mobile or hand-held applications), the concentration of quantum dots can be closer to 5%.

The ratio of quantum dots used in an optical material is determined by the emission peaks of the quantum dots used. For example, when quantum dots capable of emitting green light having a peak center wavelength in a range from about 520 nm to about 540 nm, and any wavelength in between whether overlapping or not, and quantum dots capable of emitting red light having a peak center wavelength in a range from about 615 nm to about 630 nm, and any wavelength in between whether overlapping or not, are used in an optical material, the ratio of the weight percent green-emitting quantum dots to the weight percent of red-emitting quantum dots can be in a range from about 9:1 to about 2:1, and any ratio in between whether overlapping or not.

The above ratio of weight percent green-emitting quantum dots to weight percent red-emitting quantum dots in an optical material can alternatively be presented as a molar ratio. For example, the above weight percent ratio of green to red quantum dots range can correspond to a green to red quantum dot molar ratio in a range from about 24.75 to 1 to about 5.5 to 1, and any ratio in between whether overlapping or not.

The ratio of the blue to green to red light output intensity in white trichromatic light emitted by a QD containing BLU described herein including blue-emitting solid state inorganic semiconductor light emitting devices (having blue light with a peak center wavelength in a range from about 450 nm to about 460 nm, and any wavelength in between whether overlapping or not), and an optical materials including mixtures of green-emitting quantum dots and red-emitting quantum dots within the above range of weight percent ratios can vary within the range. For example, the ratio of blue to green light output intensity therefor can be in a range from about 0.75 to about 4 and the ratio of green to red light output intensity therefor can be in a range from about 0.75 to about 2.0. In certain embodiments, for example, the ratio of blue to greenlight output intensity can be in a range from about 1.4 to about 2.5 and the ratio of green to red light output intensity can be in a range from about 0.9 to about 1.3.

Scatterers within the scope of the disclosure may be present, for example, in an amount of between about 0.01 weight percent and about 1 weight percent. Amounts of scatterers outside such range may also be useful. Examples of light scatterers (also referred to herein as scatterers or light scattering particles) that can be used in the embodiments and aspects of the inventions described herein, include, without limitation, metal or metal oxide particles, air bubbles, and glass and polymeric beads (solid or hollow). Other light scatterers can be readily identified by those of ordinary skill in the art. In certain embodiments, scatterers have a spherical shape. Preferred examples of scattering particles include, but are not limited to, TiO₂, SiO₂, BaTiO₃, BaSO₄, and ZnO. Particles of other materials that are non-reactive with the host material and that can increase the absorption pathlength of the excitation light in the host material can be used. In certain embodiments, light scatterers may have a high index of refraction (e.g., TiO₂, BaSO₄, etc) or a low index of refraction (gas bubbles).

Selection of the size and size distribution of the scatterers is readily determinable by those of ordinary skill in the art. The size and size distribution can be based upon the refractive index mismatch of the scattering particle and the host material in which the light scatterers are to be dispersed, and the preselected wavelength(s) to be scattered according to Rayleigh scattering theory. The surface of the scattering particle may further be treated to improve dispersability and stability in the host material. In one embodiment, the scattering particle comprises TiO₂ (R902+ from DuPont) of 0.2µm particle size, in a concentration in a range from about 0.01 to about 1% by weight.

The amount of scatterers in a formulation is useful in applications where the ink is contained in a clear vessel having edges to limit losses due the total internal reflection. The amount of the scatterers may be altered relative to the amount of quantum dots used in the formulation. For example, when the amount of the scatter is increased, the amount of quantum dots may be decreased.

In certain embodiments, a formulation including quantum dots and a host material can be formed from an ink comprising quantum dots and a liquid vehicle, wherein the liquid vehicle comprises a composition including one or more functional groups that are capable of being cross-linked. The functional units can be cross-linked, for example, by UV treatment, thermal treatment, or another cross-linking technique readily ascertainable by a person of ordinary skill in a relevant art. In certain embodiments, the composition including one or more functional groups that are capable of being cross-linked can be the liquid vehicle itself. In certain embodiments, it can be a co-solvent. In certain embodiments, it can be a component of a mixture with the liquid vehicle.

One particular example of a preferred method of making an ink is as follows. A solution including quantum dots having the desired emission characteristics well dispersed in an organic solvent is concentrated to the consistency of a wax by first stripping off the solvent under nitrogen/vacuum until a quantum dot containing residue with the desired consistency is obtained. The desired resin monomer is then added under nitrogen conditions, until the desired monomer to quantum dot ratio is achieved. This mixture is then vortex mixed under oxygen free conditions until the quantum dots are well dispersed. The final components of the resin are then added to the quantum dot dispersion, and are then sonicated mixed to ensure a fine dispersion.

A film comprising an optical material prepared from such finished ink can be prepared by then coating the ink via a wide variety of methods onto the surface to be coated, and then UV cured under intense illumination for some number of seconds for a complete cure. Example of methods for preparing films include, but are not limited to, a variety of film casting, spin casting and coating techniques, which are well known. Examples of several coating techniques that can be utilized include, but are not limited to, screen printing, gravure, slot, curtain and bead coating.

An example of a composition and characterization of the materials that can be used to make a film comprising an optical material taught herein (including relative amounts of quantum dots mixed with one or more host materials and other ingredients) is set forth below in Table 1:

**Table 1**

| **Component** | **Ingredient** | **%** | **Total %** | **Comments** |
|---|---|---|---|---|
| **Host material** | RD12 | 17.49% | 87.89% | Acrylate monomer from Radcure |
| | DR-150 | 70.39% | | Acrylate oligomer from Radcure |
| **Quantum Dots** | Green | 0.72% | 0.85% | |
| | Red | 0.13% | | |
| **TiO2** | TiO2 | 0.11% | 0.11% | Ti Pure R902 Plus from Dupont |
| **Coating aids** | Tego | 1.06% | 11.04% | Defoamer |
| | Cab-o-Sil™ EH-5 | 9.98% | | Viscosifier |
| | | Total | 100% | |

An example of a particular quantum dot ink formulation having a viscosity of 118 cP is shown in Table 2 below. This formulation may be used to fill a clear vessel, such as a capillary.

**Table 2**

| **Component** | **Ingredient** | **%** | **%** | **Description** |
|---|---|---|---|---|
| Binder | RD 12 | 5.87% | | Acrylate monomer from Radcure |
| | SR-423 | 24.99% | | Acrylate monomer from Sartomer |
| | CN-131 | 37.60% | | Acrylate oligomer from Sartomer |
| | DR-150 | 24.01% | 92.46% | Acrylate oligomer from Radcure |
| QD | Green | 0.91% | 1.09% | |
| | Red | 0.18% | | |
| TiO2 | | 0.28% | 0.28% | Ti Pure R902 Plus from Dupont |
| Photo initiator | KT046 | 6.18% | 6.18% | Escacure KT046 from Lamberti |
| | Total | 100.00% | 100.00% | |

Table 3 below shows an alternative formulation having a much lower viscosity of about 2 cP which provides better flowability when filling vessels such as a capillary.

**Table 3**

| **Component** | **Ingredient** | **%** | **%** | **Description** |
|---|---|---|---|---|
| Binder | SR-423 | 36.14% | | Acrylate monomer from Sartomer |
| | CN-131 | 55.90% | 92.045% | Acrylate oligomer from Sartomer |
| QD | Green | 0.90% | 1.08% | |
| | | | | |
| | Red | 0.18% | | |
| TiO2 | Ti Pure + | 0.28% | 0.28% | Ti Pure R902 Plus from Dupont |
| Photo initiator | KT046 | 6.59% | 6.59% | Escacure KT046 from Lamberti |
| | Total | 100.00% | 100.00% | |

Table 4 below shows an alternative formulation:

**Table 4**

| **Component** | **Ingredient** | **%** | **Total %** | **Comments** |
|---|---|---|---|---|
| **Host Material** | Ebercryl 150 | 84.57% | 84.57% | BisphenolA-ethoxylated diacrylate from Cytec. |
| | | | | |
| **Quantum Dots** | Green | 1.8% | 0.85% | |
| | Red | 0.4% | | |
| **TiO2** | TiO2 | 0.25% | 0.11% | Ti Pure R902 Plus from Dupont |
| **Coating aids** | Irgacure 2022 | 3% | 11.04% | photoinitiator |
| | Cab-o-Sil™ EH-5 | 9.98% | | Viscosifier |
| | | Total | 100% | |

As discussed elsewhere herein, other components such as glass beads, thixotropes, etc. can be further included in an optical material to control the viscosity and shrinkage.

Glass beads having an average diameter in a range from about 15 to about 25 microns can be preferred. The amount of glass beads in the formulation can vary from about 10% to about 40%. Typically, 30% is used. However, other size glass beads and amounts outside of these preferred ranges can be used, based on the particular application.

Examples of thixotropes include, but are not limited to, fumed metal oxides (e.g., fumed silica which can be surface treated or untreated (such as Cab-O-Sil™ fumed silica products available from Cabot Corporation), fumed metal oxide gels (e.g., a silica gel). An optical material can include an amount of thixotrope in a range from about 2 to about 10 weight percent. Other amounts outside the range may also be determined to be useful or desirable.

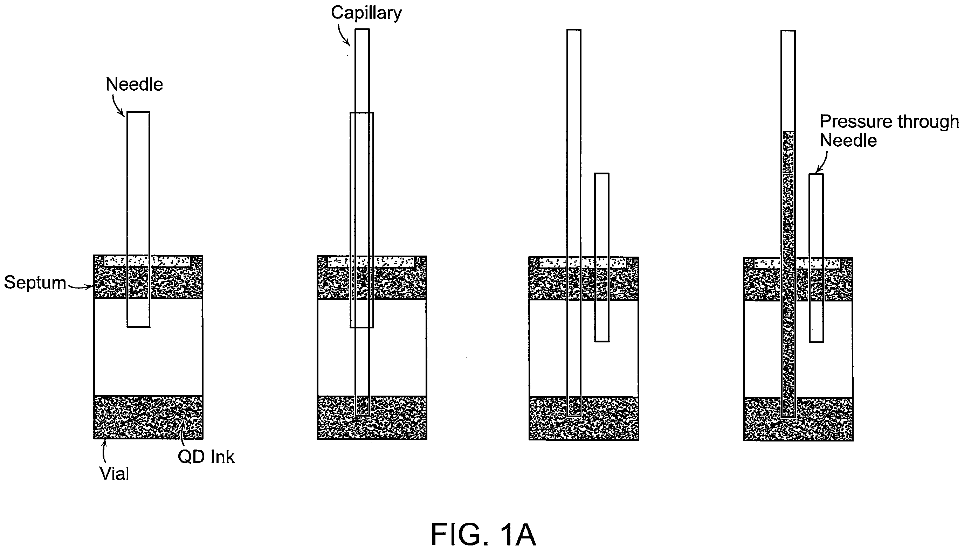

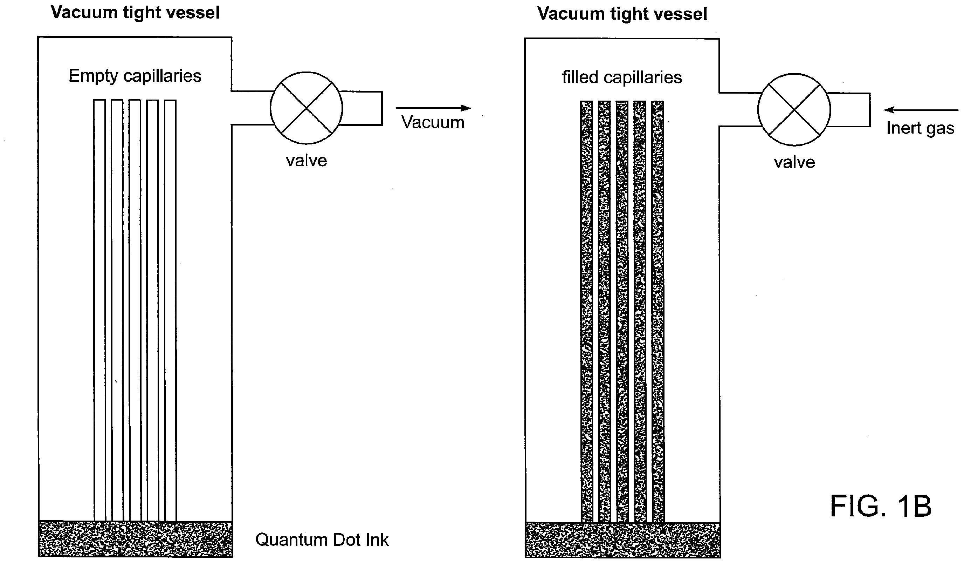

Quantum dot inks can be used to fill or otherwise occupy vessels using any conventional methods known to those of skill in the art. According to one particular aspect of the present disclosure, a pressure differential can be used to transfer an amount of quantum dot ink from one vessel to another. For example, and with reference to Figure 1A, an amount of quantum dot ink can be contained in a vial or well container capped with a septum. A larger gauge needle is then introduced through the septum and into the vial. A capillary is then introduced into the vial through the needle and into the quantum ink at the bottom of the vial. The needle is then removed and the septum closes around the capillary. A pressurizing needle attached to a syringe is then introduced through the septum. Air is then introduced into the vial using the syringe which increases the pressure in the vial, which in turn forces the quantum dot ink into the capillary. Thereafter, the filled capillary is removed from the quantum ink supply and the vial and sealed at each end. Following removal, the ink included in the sealed capillary is cured. Alternatively, the ink can be cured prior to sealing.

In certain embodiments, for example, a capillary filled with quantum ink according to a method described above is removed from the vial and UV cured in a nitrogen atmosphere.

In certain embodiments, for example, the ink can be cured with a Dymax 500EC UV Curing Flood system equipped with a mercury UVB bulb. In such case, a lamp intensity (measured as 33mW/cm² at a distance of about 7" from the lamp housing) can be particularly effective, with the capillary being cured for 10-15s and each side while being kept at a distance of 7" from the lamp housing. After curing, the edges of the capillary can be sealed.

In certain embodiments, sealing can comprise using an optical adhesive to seal one or both ends or edges of the capillary. For example, a drop of optical adhesive can be placed on each edge of the capillary and cured. An example of an optical adhesive includes, but is not limited to, NOA-68T obtainable from Norland Optics. For example, a drop of such adhesive can be placed on each edge of the capillary and cured (e.g., for 20s with a Rolence Enterprise Model Q-Lux-UV lamp).

In certain embodiments, sealing can comprise using glass to seal one or both ends or edges of the capillary. This can be done by briefly bringing a capillary filled with cured quantum dot ink into brief contact with an oxygen/Mapp gas flame until the glass flows and seals then end. Oxygen hydrogen flames may be used as well as any other mixed gas flame. The heat may also be supplied by laser eliminating the need for an open flame. In certain embodiments, both ends of a capillary filled with uncured quantum dot ink can be sealed, allowing the ink to then be photocured in the sealed capillary.

In certain embodiments, the capillary is hermetically sealed, i.e., impervious to gases and moisture.

In certain embodiments, the capillary is pseudo-hermetically sealed, i.e., at partially impervious to gases and moisture.

Other suitable techniques can be used for sealing the ends or edges of the capillary.

In another embodiment, a capillary can be filled by application of vacuum to draw the ink into the capillary. An example of a set-up for filling a capillary by application of vacuum is shown in Figure IB. A capillary tube is sealed at one end (e.g., but not limited to, with a fuel/oxygen flame) and placed open end down in an airtight vessel. Numerous capillaries can be loaded simultaneously into the same vessel. To this vessel is added enough quantum dot ink to submerge the open ends of the capillaries and the vessel is sealed. Vacuum is applied and the pressure of the system is reduced to anywhere, for example, between 1 and 1000 millitorr. The vessel is then repressurized with nitrogen causing the capillaries to fill. Air may also be used to repressurize the vessel. A slight overpressure of gas (0-60 psi) speed filling of the capillary by this method. The capillaries are then removed from th well and wiped of excess ink before further use.

In certain aspects and embodiments of the inventions taught herein, the optic including the cured quantum dot containing ink is exposed to light flux for a period of time sufficient to increase the photoluminescent efficiency of the optical material.

In certain embodiments, the optical material is exposed to light and heat for a period of time sufficient to increase the photoluminescent efficiency of the optical material.

In preferred certain embodiments, the exposure to light or light and heat is continued for a period of time until the photoluminescent efficiency reaches a substantially constant value.

In one embodiment, for example, after the optic is filled with quantum dot containing ink, cured, and sealed (regardless of the order in which the curing and sealing steps are conducted), the optic is exposed, to 25 - 35 mW/cm² light flux with a wavelength in a range from about 365nm to about 470nm, while at a temperature of in a range from about 25 to 80°C, for a period of time sufficient to increase the photoluminescent efficiency of the ink. In one embodiment, for example, the light has a wavelength of about 450 nm, the light flux is 30 mW/cm² the temperature 80 °C, and the exposure time is 3 hours.

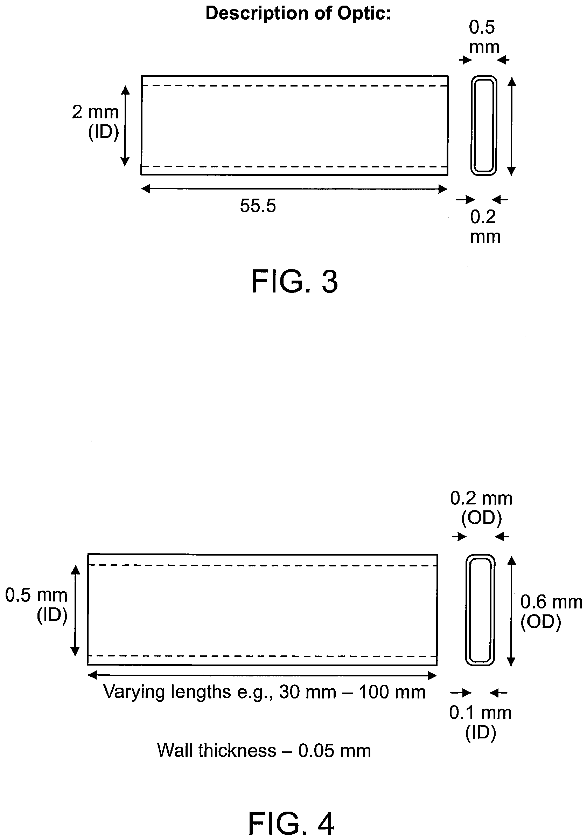

An example of a capillary, with its associated dimensions, is shown in Figure 3.

Quantum dots according to the present disclosure can also be included into various structures, such as for example, by being included as an ingredient during manufacture of the structure. Such structures include various films for use in lighting devices. Other structures and devices include an optically transparent component including quantum dots dispersed or embedded therein, a film including quantum dots which is sandwiched between barrier materials and sealed therein, a film including quantum dots which is fully encapsulated by a barrier materials.

In certain preferred embodiments, a barrier material is optically transparent to at least light having predetermined wavelengths of light passing into and out of the optic. In certain embodiments, a barrier material is at least 90% optically transparent to at least predetermined wavelengths of light passing into and out of the optic. In certain embodiments, a barrier material is at least 95% optically transparent to at least predetermined wavelengths of light passing into and out of the optic. In certain embodiments, a barrier material is at least 99% optically transparent to at least predetermined wavelengths of light passing into and out of the optic.

In certain preferred embodiments, a barrier material will not yellow or discolor so as substantially alter the optical properties of the optic.

In certain preferred embodiments, a barrier material will not partially or fully delaminate during the useful lifetime of the optic.

In certain preferred embodiments, the properties of a barrier material will have minimal impact on the external quantum efficiency of an optical material.

In certain preferred embodiments, a barrier material can be formed under conditions that are not detrimental to an optical material and the external quantum efficiency of an optical material.

A barrier material is preferably a material that is substantially impervious to oxygen. In certain embodiments, a barrier layer is substantially impervious to oxygen and water. Inclusion of a barrier material over an optical material may be desirable in embodiments in which the optical material is not otherwise protected from environmental effects.

Example of suitable barrier films or coatings include, without limitation, a hard metal oxide coating, a thin glass layer, and Barix coating materials available from Vitex Systems, Inc. Other barrier films or coating can be readily ascertained by one of ordinary skill in the art.

Additional information that may be useful in connection with the present disclosure and the inventions described herein is included in International Application No. PCT/US2009/002796 of Coe-Sullivan et al, filed 6 May 2009, entitled "Optical Components, Systems Including An Optical Component, And Devices"; International Application No. PCT/US2009/002789 of Coe-Sullivan et al, filed 6 May 2009, entitled : "Solid State Lighting Devices Including Quantum Confined Semiconductor Nanoparticles, An Optical Component For A Solid State Light Device, And Methods"; International Application No. PCT/US2010/32859 of Modi et al, filed 28 April 2010 entitled "Optical Materials, Optical Components, And Methods"; International Application No. PCT/US2010/032799 of Modi et al, filed 28 April 2010 entitled "Optical Materials, Optical Components, Devices, And Methods"; International Application No. PCT/US2008/007901 of Linton et al, filed 25 June 2008 entitled "Compositions And Methods Including Depositing Nanomaterial"; U.S. Patent Application No. 12/283609 of Coe-Sullivan et al, filed 12 September 2008 entitled "Compositions, Optical Component, System Including An Optical Component, Devices, And Other Products"; International Application No. PCT/US2008/10651 of Breen et al, filed 12 September 2008 entitled "Functionalized Nanoparticles And Method"; International Application No. PCT/US2009/004345 of Breen et al, filed 28 July 2009 entitled "Nanoparticle Including Multi-Functional Ligand And Method", U.S. Patent Application No. 61/234179 of Linton et al. filed 14 August 2009 entitled "Lighting Devices, An Optical Component For A Lighting Device, And Methods"; U.S. Patent Application No. 61/252743 of Linton et al filed 19 October 2009 entitled "An Optical Component, Products Including Same, And Methods For Making Same"; U.S. Patent Application No. 61/291072 of Linton et al filed 30 December 2009 entitled "An Optical Component, Products Including Same, And Methods For Making Same"; and International Application No. PCT/US2007/024320 of Clough et al, filed 21 November 2007, entitled "Nanocrystals Including A Group IIIa Element And A Group Va Element, Method, Composition, Device And Other Products".

The following examples are set forth as being representative of the present disclosure. These examples are not to be construed as limiting the scope of the disclosure as these and other equivalent embodiments will be apparent in view of the present disclosure, figures, and accompanying claims.

### EXAMPLE 1

### A Trichromatic White Light Source Using a Blue LED and a Mixture of Red and Green Quantum Dots

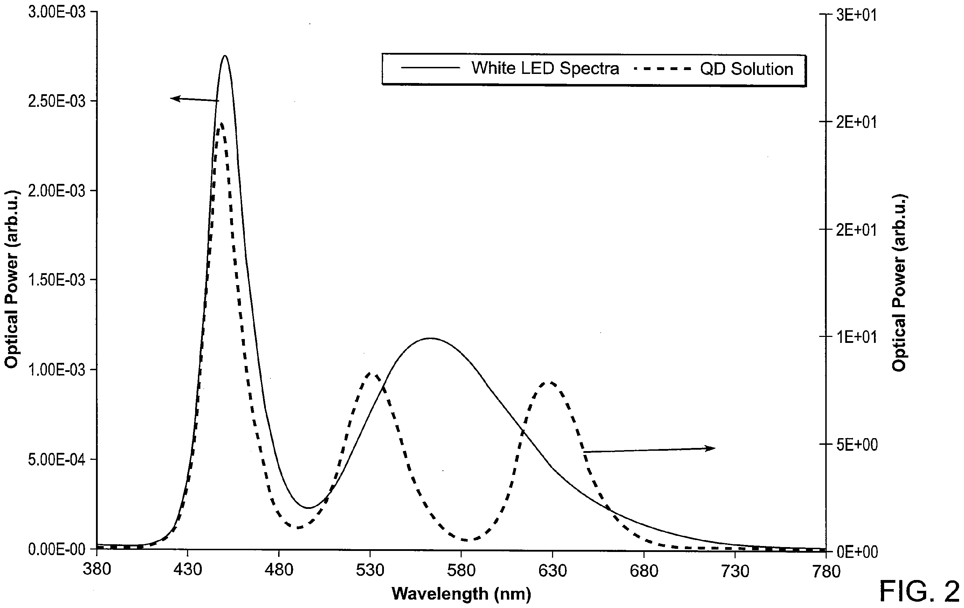

A trichromatic white light source was created using film, as described below, including green quantum dots with a peak center wavelength of 523 nm and a FWHM of 37 nm, red quantum dots with a peak center wavelength of 617 nm and a FWHM of 32 nm, and a blue LED with a peak emission around 450 nm, arranged in a direct lit configuration. Blue light from the LED was used to excite a mixture of the green and red quantum dots. The emission spectra of the quantum dot mixture along with the spectra of the control white LED source are shown in Figure 2. (The control white LED source is Sharp Microelectronics, Manufacturer Part No. GM5BW97333A (Description: LED White 115000K 20 MA 3.2V PLCC4))

The red and green quantum dots were prepared generally in accordance with the following procedures:

### Preparation of Semiconductor Nanocrystals Capable of Emitting Green Light:

*Synthesis of ZnSe Cores:* 7.0 mmol diethyl zinc was dissolved in 50 mL of tri-n-octylphosphine and mixed with 10 mL of 1 M TBP-Se. 0.374 mol of Oleylamine was loaded into a 250 mL 3-neck flask, dried and degassed at 90°C for one hour. After degassing, the flask was heated to 310°C under nitrogen. Once the temperature reached 310°C, the Zn solution was injected and the reaction mixture was heated at 270°C for 15-30 minutes while aliquots of the solution were removed periodically in order to monitor the growth of the nanocrystals. Once the first absorption peak of the nanocrystals reached 350 nm, the reaction was stopped by dropping the flask temperature to 160°C and the ZnSe core materials were used without further purification for preparation of CdZnSe cores.

*Synthesis of CdZnSe Cores:* 22.4 mmol dimethylcadmium was dissolved in 80 mL of tri-n-octylphosphine and mixed with 24 mL of 1 M TBP-Se. In a 1 L glass reactor, 0.776 mol of trioctylphosphine oxide and 42 mmol of octadecylphosphonic acid were loaded, dried and degassed at 120°C for one hour. After degassing, the oxide/acid was heated to 160°C under nitrogen and the entire ZnSe core reaction mixture (see above) was cannula transferred at 160°C into the 1 L reactor, immediately followed by the addition of Cd/Se solution over the course of 20 minutes via syringe pump. The reaction mixture was then heated at 150°C for 16-20 hours while aliquots of the solution were removed periodically in order to monitor the growth of the nanocrystals. The reaction was stopped by cooling the mixture to room temperature once the emission peak of the CdZnSe cores reached 480 nm. The CdZnSe cores were precipitated out of the growth solution inside a nitrogen atmosphere glove box by adding a 2:1 mixture of methanol and n-butanol. The isolated cores were then dissolved in hexane and used to make core-shell materials.

*Synthesis of CdZnSelCdZnS Core-Shell Nanocrystals:* 0.72 mol of trioctylphosphine oxide and 70 mmol of 3,5-di-*tert*-butyl-4-hydroxybenzylphosphonic acid were loaded into a 1 L glass reactor. The mixture was then dried and degassed in the reactor by heating to 120°C for about an hour. The reactor was then cooled to 75°C and the hexane solution containing isolated CdZnSe cores (2.74 mmol Cd content) was added to the reaction mixture. The hexane was removed under reduced pressure. Dimethyl cadmium, diethyl zinc, and hexamethyldisilathiane were used as the Cd, Zn, and S precursors, respectively. The Cd and Zn were mixed in a 3:10 ratio while the S was equimolar relative to Cd and Zn combined. The Cd/Zn (7.2/16.9 mmol of dimethylcadmium and diethylzinc) and S (24.2 mmol of hexamethyldisilathiane) samples were each dissolved in 40 mL of trioctylphosphine inside a nitrogen atmosphere glove box. Once the precursor solutions were prepared, the reactor was heated to 150 °C under nitrogen. The precursor solutions were added dropwise over the course of 2 hours at 150 °C using a syringe pump. After the shell growth, the nanocrystals were transferred to a nitrogen atmosphere glovebox and precipitated out of the growth solution by adding a 3:1 mixture of methanol and isopropanol. The isolated core-shell nanocrystals were then dissolved in hexane and used to make quantum dot composite materials. The material specifications were as follows: Emission = 523 nm; FWHM = 37 nm; QY = 73% in toluene.

### Preparation of Semiconductor Nanocrystals Capable of Emitting Red Light with 3,5-di-tert-butyl-4-hydroxybenzylphosphonic acid

*Synthesis of CdSe Cores:* 26.23 mmol cadmium acetate was dissolved in 235.4 mmol of tri-n-octylphosphine at 100°C in a 250 mL 3-neck round-bottom flask and then dried and degassed for one hour. 465.5 mmol of trioctylphosphine oxide and 59.8 mmol of octadecylphosphonic acid were added to a 0.5 L glass reactor and dried and degassed at 140°C for one hour. After degassing, the Cd solution was added to the reactor containing the oxide/acid and the mixture was heated to 270°C under nitrogen. Once the temperature reached 270°C, 243 mmol of tri-n-butylphosphine was injected into the flask. The temperature of the mixture was then raised to 295 °C where 60 mL of 1.5 M TBP-Se was then rapidly injected. The reaction mixture temperature dropped to 270 °C for 2 minutes and then the heating mantle was removed from the reaction flask and the apparatus cooled via two air guns. The first absorption peak of the nanocrystals was 560 nm. The CdSe cores were precipitated out of the growth solution inside a nitrogen atmosphere glovebox by adding a 3:1 mixture of methanol and isopropanol. The isolated cores were then dissolved in hexane and used to make core-shell materials.

*Synthesis of CdSe*/*CdZnS Core-Shell Nanocrystals:* 517.3 mmol of trioctylphosphine oxide and 48.3 mmol of 3,5-di-*tert*-butyl-4-hydroxybenzylphosphonic acid were loaded into a 0.5 L glass reactor. The mixture was then dried and degassed in the reactor by heating to 120°C for about an hour. The reactor was then cooled to 70 °C and the hexane solution containing isolated CdSe cores (1.98 mmol Cd content) was added to the reaction mixture. The hexane was removed under reduced pressure. Dimethyl cadmium, diethyl zinc, and hexamethyldisilathiane were used as the Cd, Zn, and S precursors, respectively. The Cd and Zn were mixed in equimolar ratios while the S was in two-fold excess relative to the Cd and Zn. The Cd/Zn (6.82 mmol of dimethylcadmium and diethylzinc) and S (27.3 mmol of hexamethyldisilathiane) samples were each dissolved in 80 mL of trioctylphosphine inside a nitrogen atmosphere glove box. Once the precursor solutions were prepared, the reaction flask was heated to 155°C under nitrogen. The precursor solutions were added dropwise over the course of 2 hours at 155°C using a syringe pump. After the shell growth, the nanocrystals were transferred to a nitrogen atmosphere glovebox and precipitated out of the growth solution by adding a 3:1 mixture of methanol and isopropanol. The isolated core-shell nanocrystals were then dissolved in toluene and used to make quantum dot composite materials. The material specifications were as follows: Abs = 600 nm; Emission = 617 nm; FWHM = 32 nm; QY = 78% in Toluene

The formulation used in preparing the film included the following components in the amounts specified:

| | | |
|---|---|---|
| RD12 (monomer) | % | 18.1% |
| DR150 (oligomer) | % | 72.5% |
| TiO2 | % | 0.1% |
| Tego | % | 0.9% |
| Dots | % | 0.6% |
| Carb-o-sil | % | 7.8% |
| | | |
| Total | % | 100.0% |
| | | |
| G:R ratio | | 3.5:1 |

The description of the film preparation and film characteristics are as follows:

| Thickness | Microns | 71 |
|---|---|---|
| Coating Process | | 3 pass of handscreened (137 mesh) |
| Cure conditions | | 10 sec. for each pass under Ns, H bulb |
| Lamination conditions | | NOA-65-cured 20 sec under N2, H bulb |
| Treatment | | 450 nm blue light, flux 25-30 mW/cm², at 55-60 °C, overnight |

The cured film had peak emissions at 535 nm (FWHM 37) and 629 nm (FWHM 38), as measured by a Cary.

The film was screened onto a CF-100 barrier film from CP Films, Inc.

The product design parameters that are of interest to LCD designers are color gamut and power efficiency. Aligning quantum dot emissions relative to peak red-green-blue (RGB) transmission wavelengths is important to achieve the maximum useful color gamut possible.

The ratio of weight percent green to red quantum dots is driven mainly by the choice of the peak emission wavelengths of the red and green quantum dots that are used to create the mixture. The choice of peak emission wavelength in turn is driven by the product design parameters.

The color gamut can be further increased by co-optimizing the quantum dot emission with color filter transmission windows.

The power efficiency of this display can be increased by selecting a lower wavelength red quantum dot, for example red quantum dots having a peak center emission at 620 nm and/or 615 nm instead of the 630 nm red quantum dot chosen. An increase in power efficiency may result in a lowering of the color gamut.

According to certain aspects, when the peak center wavelength of the red quantum dots is changed, the ratio of green to red quantum dots may be altered to achieve the same color point at the front of screen. Examples of preferred green to red quantum dot weight percent ratios for use in various embodiments of the present invention include, but are not limited to, ratios in a range from about 3.5 to 1 to about 5.5 to 1.

### EXAMPLE 2

### Backlight Units Using a Blue LED and a Mixture of Red and Green Quantum Dots

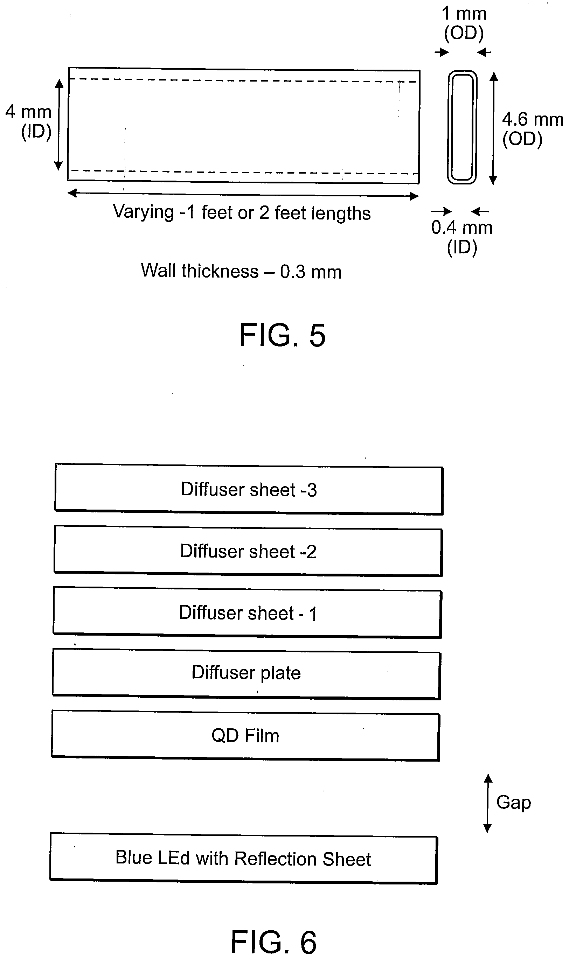

In accordance with certain embodiments of the disclosure, backlight units are provided which utilize quantum dots to generate trichromatic white light for transmission into and through a light guide. The backlight units provide a higher color gamut and better power efficiency compared to white LEDs. The quantum dots may be present in a film having dimensions similar to the face of a light guide and adjacent thereto or they may be present in a capillary or other vessel with dimensions similar to an edge of a light guide and adjacent thereto. Light generated by quantum dots as described herein can be transmitted through an edge of a light guide or a face of a light guide. According to one embodiment utilizing a quantum dot film shown in Figure 6, a quantum dot backlight unit stack is depicted in which light from an LED source (shown here as a blue LED source with a light guiding reflection sheet) is positioned on the bottom of the backlight. Preferably, the light source is spaced from the quantum dot film (as shown). A diffuser plate is placed adjacent the quantum dot film. One or more diffuser sheets can be placed adjacent the diffuser plate. One or more other functional sheets of films (e.g., a light polarizing film, a reflective polarizer or dual brightness enhancement film, and/or structured films (e.g., that can include prism features) can also be included in the stack.

Blue light from the LEDs pass directly through the quantum dot-containing film, where predetermined amounts of green and red light are mixed with the remaining blue light to create the tri-chromatic white light. An optical film stack including, for example, but not limited to, a diffuser plate, one or more diffuser sheets and optionally other functional sheets or films is placed on top of the quantum dot-containing film. This configuration may be referred to as a direct-lit configuration. (While the figure depicts an example of an optical film stack including three diffuser sheets, other numbers of diffuser sheets and/or other optical film stack structures including various numbers and types of functional sheets or films can be used by the skilled artisan.)

Light from the blue LED may excite the quantum dot film, which, upon excitation, may emit white light that may then be transmitted through the diffuser plate. Light transmitted through the diffuser plate may exit as a nearly lambertian white source. This uniformly distributed light may travel through one or more diffuser sheets where light may further be collimated towards normal. Finally, the collimated light may travel through a reflective polarizer (or DBEF) on the outer layer of the stack before entering the display panel.

Figure 2 compares the spectra of a quantum dot film/blue LED combination (generally as described in Example 1) and a control white LED control (as described in Example 1). As shown in Figure 2, the use of narrow band quantum dot emitters may minimize the loss of power encountered through the use of color filters used in conventional LCD displays. To arrive at a predetermined color point on a color map with quantum dot BLUs, in addition to considering the peak center wavelength of the quantum dots used, the ratio and concentrations of different color quantum dots can be altered according to aspects of the present invention.

In accordance with additional aspects, the optical film stack and color filters employed in the display system can be altered as desired to achieve a predetermined color point when used in connection with quantum dot backlight units. For instance, when integrating the quantum film into an LED backlight, the existing luminance profile and color variation specifications of conventional direct lit backlights are considered. For desired performance, the color point of the quantum dot backlight can be matched to the white point of the control, which is a conventional LED white backlight, at the front of screen (i.e., the color of the white light passing through the LCD panel has to match). As a point of reference, typical front of screen [CIE XY] coordinates of a white light source in a typical TV panel is 0.28, 0.28.

The thickness of the optical film can be from about 0.1 to about 500 micrometers. However, thicknesses outside of this range can be used based on the particular design and use of the backlight unit apparatus and/or application in which it is to be used. For example, the thickness of an optical film can vary between 50 micrometers to about 500 micrometers, depending upon the application. Optical films can be cut to match the dimensions of the particular display or other application being considered.

### EXAMPLE 3

### General method of creating trichromatic white light using a blue LED and a mixture of red and green quantum dots

A strip of blue LEDs is provided in a backlight. The preferred peak center wavelength of the blue LEDs is 450 +/- 5 nm. Increasing the blue wavelength beyond 460 nm reduces the color gamut as blue light from the LED leaks into the green channel.

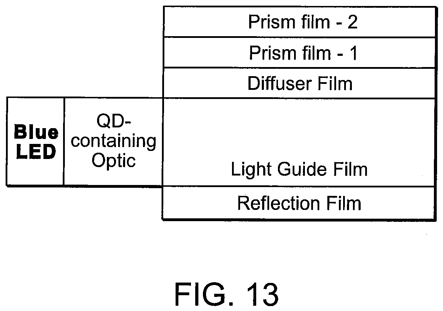

A mixture of green and red quantum dots mixed in an appropriate ratio is provided through an optic or a film. In the case of an optic, the optic is inserted between the LED and the light guide film or plate. In the case of film, it is inserted as a part of the optical film stack. The description of the optical film stack in case of edge optic is shown in Figure 13.

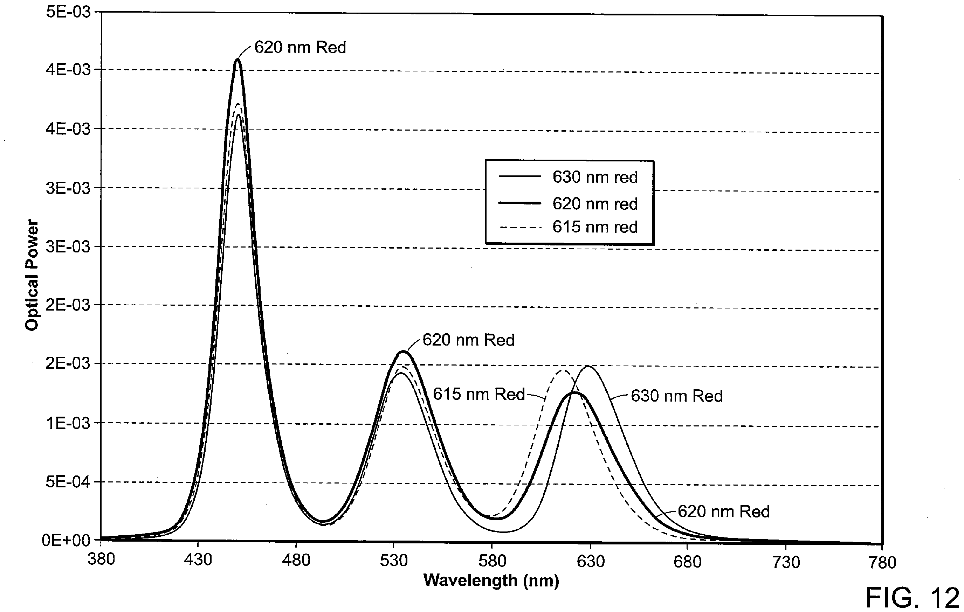

The ratio of green to red quantum dots is selected to achieve the desired front of screen color point. In certain embodiment, ratios of weight percent Green to Red quantum dots can vary, for example, from about 3.5:1 to about 5.5: 1. Figure 12 shows the spectral profile of tri-chromatic white light coming from the backlight. The CIE x,y co-ordinates that describe the whiteness of the light falls in the range 0. 27+/- 0.01, 0.235 +/- 0.005. The white light from the backlight passes through a panel which has a color filter. The resultant white light coming out from the panel (called as "front of screen") falls in the CIE x, y range 0.28+/- 0.01, 0.28+/-0.005. The ratio of weight percent green to red quantum dots included in the quantum dot containing optic can be adjusted such that the white light coming from the panel matches D65 illuminant with CIE x, y values (0.31 , 0.33). The front of screen color point can be tuned to any desired value as described elsewhere herein.

### EXAMPLE 4

### Backlight Units Using a Thin Capillary Optic or Film

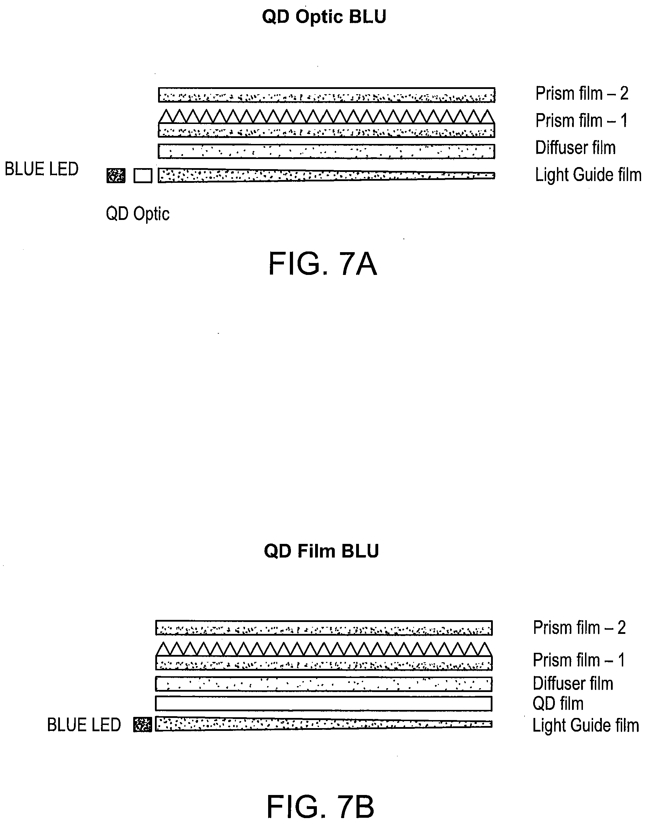

Figure 7a depicts a quantum dot optic backlight unit in accordance with an embodiment of the present invention. As shown in Figure 7a, a thin capillary optic containing quantum dots is positioned adjacent an edge surface of a light guide film Light from one or more blue LED enters the capillary optic that includes a mixture of quantum dots capable of emitting red light and quantum dots capable of emitting green light. A portion of the blue light is emitted from the capillary optic as red light and green light, and a portion is emitted as blue light. Such combination of emitted red, green, and blue light creates tri-chromatic white light. The light guide film redirects the resulting trichromatic white light towards the viewer. A diffuser film and a pair of prism films further collimate the light towards the viewer. A reflection film (not shown) can be optionally applied to the surface of the light guide film opposite the diffuser film to avoid loss of light out of the bottom of the light guide film. The design shown in Figure 7a can be preferred for use in small backlight units.

A light guide is desirably optically transparent to light from a light source and to light emitted by the quantum dots. In certain embodiments and aspects of the inventions described herein including a light guide, the light guide can comprise a rigid material, e.g., glass, polycarbonate, thick acrylic, quartz, sapphire, or other known rigid materials with light guide characteristics.

In certain embodiments and aspects of the inventions described herein including a light guide, the light guides can alternatively comprise a flexible material, e.g., a polymeric material such as plastic or silicone. Various particular examples include, but not limited to thin acrylic, epoxy, PEN, PET, PE.

In certain embodiments and aspects of the inventions described herein including a light guide, the light guide is planar. Light guides may also be referred to herein as light guide plates or light guide films.

In certain embodiments and aspects of the inventions described herein including a light guide, at least the texture of the surface of the light guide from which light is emitted is selected to enhance or otherwise alter the pattern, angle, or other feature of light transmitted therethrough. For example, in certain embodiments, the surface may be smooth; in certain embodiments, the surface may be non-smooth (e.g., the surface is roughened or the surface includes one or more raised and/or depressed features); in certain embodiments, the surface may include both smooth and non-smooth regions.

In certain embodiments, for example, a light guide or optic (or optical component) may further include outcoupling members or structures across a surface thereof.

In certain embodiments and aspects of the inventions described herein, the geometrical shape and dimensions of a light guide and/or an optic (or optical component) can be selected based on the particular end-use application. In certain embodiments, the thickness of the light guide can be substantially uniform. In certain embodiments, the thickness of the light guide can be non-uniform (e.g., tapered).

The optic within the scope of the present disclosure is generally a clear vessel within which are quantum dots. One example of a suitable vessel is a capillary of generally square cross section. However, other shapes are included within the scope of the present disclosure such as tetragonal (e.g., rectangular cross section, square cross section, trapezoidal cross section, etc.) circular cross section, oval cross section, and oblong cross section. The purpose of the optic is to allow light emitted from the quantum dots to pass through and into the light guide. With this implementation, the thickness of the optic may be adjusted to match the light guide film thickness to ensure maximum coupling of the light from the quantum dot optic and the LEDs. In one example of this implementation, a blue LED source was chosen to excite capillaries filled with red and green quantum dots.

Capillaries of square and rectangular cross-sections can be preferred. In addition, capillaries with rectangular cross-sections can be more preferred over square cross- sections. The rectangular cross-section can be more preferred in that it enables making thin capillaries that are wide enough to match the thickness of the light guide plate adjacent which the capillary can be positioned and aligned. In backlights used in mobile devices, due their size, there is typically little room between the light source (e.g. an inorganic semiconductor LED) and the light guide plate. In such cases, thin capillary (50-100 micrometer thickness - Inner dimension) can be used. The height of the optic (outer dimension) is designed to match the light guide plate thickness. The dimension is typically less than 0.75 mm and is in the range 0.6 to 0.3 mm. The wall thickness is typically of the order of 50 micrometer to ensure that the active area is sufficient to create color conversion. Figures 4 and 5 illustrate the typical capillaries used in mobile applications (small backlights) and larger backlights.

An example of a capillary, with its associated dimensions, suitable for use in small backlight units is shown in Figure 4.

An example of a capillary, with its associated dimensions, suitable for use in larger backlight units is shown in Figure 5.

According to one embodiment, a mobile BLU is illuminated with 7 blue LEDs with a peak transmission around 450 nm. A quantum dot containing optic BLU was implemented by inserting a thin optic housing red and green quantum dots between the blue LEDs and the light guide film. Upon excitation of the mixture of red and green quantum dots, white light is produced and is transmitted into the light guide.

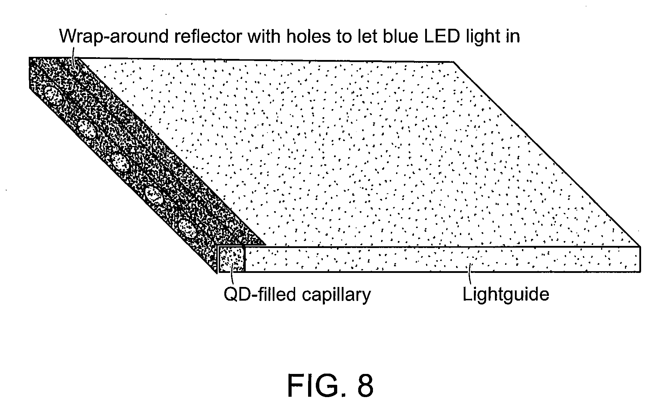

Quantum dots are isotropic emitters; they emit light in all directions. This means light from quantum dots in the capillaries are emitted towards light guide plate and also in directions other than the light guide plate. An optional reflector or reflector material can be wrapped around the capillary or otherwise applied on up to three sides to recycle the light and focus it towards the light guide. In such a scenario, on the side of the capillary facing the LED(s), appropriate openings are provided in the light reflective material or reflector for blue light to leave the LED and enter the optic. The schematic shown in Figure 8 provides an example of this configuration.

As shown in Figure 8, to optically couple the capillary optic and/or blue LED to a light guide, the capillary is place adjacent an edge surface of the light guide and then wrapped or coated with reflective material or film (e.g., aluminized Mylar, ESR, white film). Preferably, there is an air gap between the capillary and the edge of the light guide. Alternatively, an optical adhesive can be used to couple the capillary to the edge of the light guide. For example, a film may wrap completely around the quantum dot- filled capillary and connect to the light guide. Optionally, for example, a film may wrap around both the LED and the quantum dot-filled capillary. Such an embodiment can assist in the alignment, coupling, and holding of the capillary to the light guide. In examples in which a film wraps around only the capillary, holes may be provided in the reflective film aligned with the excitation LEDs to let the excitation light pass into the capillary.

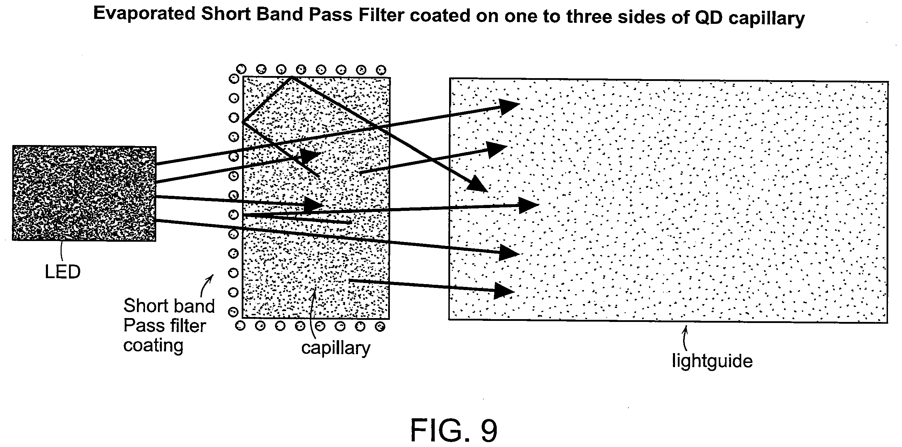

Alternatively, and with reference to Figure 9, a short band pass filter may be deposited on three sides of the capillary to pass LED light but reflect quantum dot- generated light into the light guide. Short band pass filter materials are available from Barr Precision Optics And Thin Film Coating. Suitable short band pass filter materials can be readily identified by a person of ordinary skill in the relevant art. Methods of coating a capillary with a short band pass filter material include evaporative coating, and other techniques that can be readily ascertained by the skilled artisan. A preferred band pass filter should allow nearly complete transmission of blue light coming from the LED. The light from the LED comes in a 120 degree cone. The band pass filter should be capable of transmitting the light coming within that cone. The band pass filter should be capable of reflecting back green and red light emitted by the quantum dots. This light gets recycled within the optic and gets coupled into the light guide.

An optical coupling layer that maximizes coupling of light from the optic to the light guide may also be provided to maximize the brightness.

In accordance with certain embodiments of the disclosure, a film containing quantum dots may be inserted into the optical film stack (also referred to herein as a QD film BLU), as shown in Figure 7b, between the light guide and the diffuser with the blue LED positioned at the edge of the film as opposed to being placed alternative at the face of the film, as shown in Figure 6. In both Figures 7a and 7b, the quantum dots may be placed remotely from the LED chip. Also, in both cases, the concentration of quantum dots may be adjusted to meet the desired color point at the front of screen (i.e. after panel). A conventional white LED backlight of similar size may be used as a control system for comparing the performance of the QD BLUs to conventional systems.

According to this embodiment, a quantum dot BLU is implemented through a blue LED matrix (e.g., 5 blue LEDs with a peak transmission around 450 nm) and a quantum dot film along one face of the light guide. Upon excitation of the mixture of red and green quantum dots in the film, white light is produced and is transmitted into the light guide.

The luminance uniformity of a direct lit backlight including a quantum dot film and blue LED as described above in Example 1 is comparable to the control white LED described therein.

Importantly, however, the quantum dot BLU can have a larger color gamut compared to a display that uses a conventional white LED backlight. According to this aspect of the disclosure, the quantum dot BLU provides a further power savings by allowing for the tuning of brightness with ambient lighting conditions.

In accordance with the embodiments shown in Figures 7a and 7b, the quantum dot film and quantum dot capillary optic implementations provide two different ways of increasing color gamut in LCD displays without the inherent implementation complexity associated with conventional RGB LEDs. The quantum dot film BLU may be most appropriate for implementation in edge-lit backlight systems, while the quantum dot optic BLU may be used in both edge lit and direct lit systems. For large area LCDs, the quantum dot optic implementation may be more economical, given the amount of quantum dots needed to achieve the desired color point.

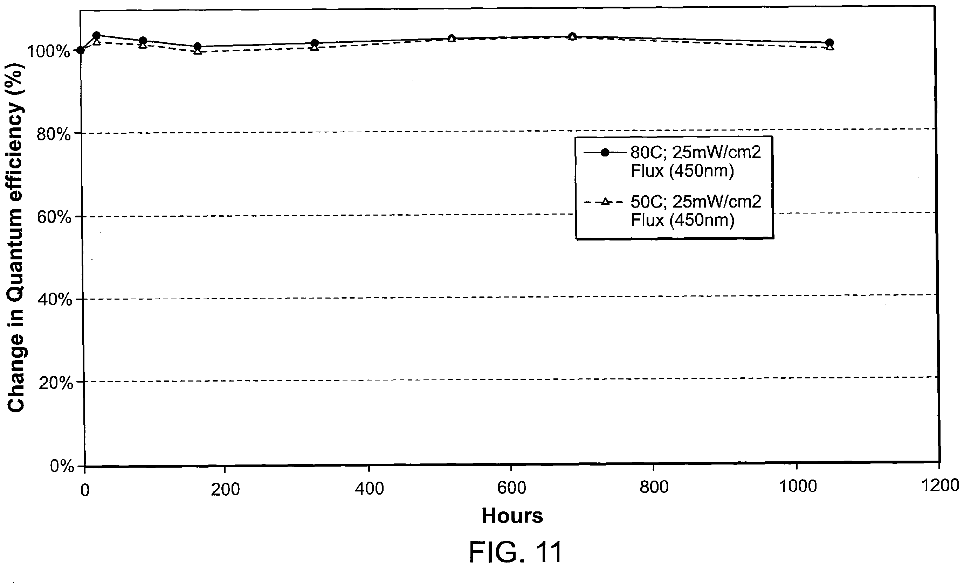

Figure 11 shows the change in quantum efficiency of the quantum dot optic as a function of time when the quantum dot optic is exposed to high energy blue LED light (∼25 mW/cm²) and temperatures of up to 80°C. The quantum dot optic is subject to higher light flux and temperature compared to the quantum dot film due to the optic's proximity to the LED. As shown in Figure 11, no change in quantum efficiency is observed for over 1000 hours for each of the temperature conditions.

In a quantum dot optic BLU, coupling of light into the light guide film may be less efficient under certain circumstances as quantum dots are isotropic emitters, i.e., they emit light in all directions uniformly. Aspects of the present disclosure include directing light emitted in directions other than the light guide film toward the light guide film by efficient coupling mechanisms described above. The improved coupling of the quantum dot light source to the light guide increases the brightness of quantum dot BLU relative to conventional white BLU brightness.

As used herein, "external quantum efficiency" (also referred to herein as "EQE" or "photoluminescent efficiency) is measured in a 12" integrating sphere using a NIST traceable calibrated light source, using the method developed by Mello et al., Advanced Materials 9(3):230 (1997).

As used herein, the singular forms "a", "an" and "the" include plural unless the context clearly dictates otherwise. Thus, for example, reference to an emissive material includes reference to one or more of such materials.

When an amount, concentration, or other value or parameter is given as either a range, preferred range, or a list of upper preferable values and lower preferable values, this is to be understood as specifically disclosing all ranges formed from any pair of any upper range limit or preferred value and any lower range limit or preferred value, regardless of whether ranges are separately disclosed. Where a range of numerical values is recited herein, unless otherwise stated, the range is intended to include the endpoints thereof, and all integers and fractions within the range. It is not intended that the scope of the invention be limited to the specific values recited when defining a range.

Other embodiments of the present invention will be apparent to those skilled in the art from consideration of the present specification and practice of the present invention disclosed herein. It is intended that the present specification and examples be considered as exemplary only with a true scope of the invention being indicated by the following claims.

## Claims

1. A backlight unit apparatus for generating white light comprising:
a light source capable of emitting blue light;
an optical material comprising a host material and a first quantum dots capable of emitting green light and second quantum dots capable of emitting red light, wherein the weight percent ratio of the first quantum dots to the second quantum dots in the optical material is in a range from 9:1 to 2:1,
wherein the light source is positioned to be capable of illuminating the optical material
and wherein the optical material is positioned adjacent to an edge surface of a transparent light guide; and
**characterised in that** the backlight unit further comprises an optic comprising a transparent capillary comprising the optical material, wherein a light reflective material partially surrounds the capillary.

2. The backlight unit apparatus in accordance with claim 1, wherein the blue light of the light source has a peak center wavelength in a range from 450 nm to 460 nm and the optical material comprises first quantum dots capable of emitting green light having a peak center wavelength in a range from 520nm to 540 nm and second quantum dots capable of emitting red light having a peak center wavelength in a range from 615 nm to 630 nm.

3. The backlight unit apparatus in accordance with claim 1 or 2, wherein the total concentration of first quantum dots and second quantum dots in the optical material is in a range from 0.5 to 10 weight percent.

4. The backlight unit apparatus in accordance with claim 1 or 2, wherein the ratio of the weight percent of first quantum dots to the weight percent of the second quantum dots in the optical material is in a range from 6:1 to 2:1, in particular in a range from 5:1 to 3:1.

5. The backlight unit apparatus in accordance with claim 1 or 2, wherein the optical material further includes scatterers in an amount in a range from 0.1 to 1 weight percent.

6. The backlight unit apparatus in accordance with claim 1 or 2, wherein the ratio of intensity of blue light to green light in the white light generated from the apparatus is in a range from 0.75 to 4 and the ratio of intensity of green light to red light in the white light generated from the apparatus is in a range from 0.75 to 2.0.

7. The backlight unit apparatus in accordance with claim 1 or 2 or claim 6, wherein each of the red and green light components of the white light have a peak emission with a FWHM in a range from 25 nm to 50 nm.

8. The backlight unit apparatus in accordance with claim 1 or 2, wherein the first quantum dots and the second quantum dots are homogeneously distributed throughout the host material.

9. The backlight unit apparatus in accordance with claim 1, wherein the light reflective material partially surrounds the capillary such that light emitted from the optical material in a direction away from the edge of the light guide is reflected toward the edge of the light guide.

10. The backlight unit apparatus in accordance with claim 9, wherein the light reflective material contacts a portion of a top surface of the light guide, surrounds a part of the optical material and contacts a portion of a bottom surface of the light guide such that light emitted from the optical material in a direction away from the edge of the light guide is reflected toward the edge of the light guide.

11. The backlight unit apparatus in accordance with claim 9 or 10, wherein the light reflective material includes an opening adjacent to the light source such that light emitted from the light source can enter the optical material.

12. The backlight unit apparatus in accordance with claim 9, wherein a light reflective material contacts a portion of a top surface of the light guide, surrounds the light source and a part of the optical material and contacts a portion of a bottom surface of the light guide such that light emitted from the optical material in a direction away from the edge of the light guide is reflected toward the edge of the light guide.

13. The backlight unit apparatus in accordance with claim 1, 9 or 10 wherein the light reflective material comprises a short band pass filter allowing light from the light source to pass through while reflecting light from the first quantum dots and the second quantum dots.

14. The backlight unit apparatus in accordance with of claim 1, wherein the optical material is positioned adjacent a face surface of the light guide and included in a film.

15. The backlight unit apparatus in accordance with claim 13, wherein the short band pass filter can selectively transmit blue light having a wavelength in a range from 420 nm to 480 nm and can selectively reflect light having a wavelength in a range from 481 nm to 680 nm.

16. The backlight unit apparatus in accordance with claim 1, wherein one surface along the length of the capillary is free of light reflective material, in particular nearest the light guide.

17. The backlight unit apparatus in accordance with claim 15, wherein transmission of the short band pass filter in the in the range from 420 nm to 480 nm is at least 90%.

18. The backlight unit apparatus in accordance with claim 15 or 17, wherein transmission of the short band pass filter in the in the range from 481 nm to 680 nm is no greater than 5%.

19. The backlight unit apparatus in accordance with claim 1 or 9, wherein the capillary has at least one of:
a circular cross-section,
tetragonal cross-section,
square cross-section,
rectangular cross-section, and
trapezoidal cross-section.

20. The backlight unit apparatus in accordance with claim 19, wherein in the case the capillary has a tetragonal-cross section, the light reflective material is coated on a surface of the capillary nearest the light source, in particular on the top and bottom surfaces of a surface of the capillary.

21. The backlight unit apparatus in accordance with claim 1 or 9, wherein the ends of the capillary are coated with a material to prevent light emission from the ends thereof.

22. The backlight unit apparatus in accordance with claim 1, wherein the light reflective material is coated on part of the surface along the length of the capillary opposite the surface free of light reflective material, and
wherein the surface is coated with light reflective material, with a predetermined arrangement of one or more predefined areas being uncoated for placement of a light source at each predefined area such that light emitted from the light source can enter the optical material.

23. The backlight unit apparatus in accordance with claim 1, wherein the optical material has an EQE of at least 70%.

24. The backlight unit apparatus in accordance with claim 1, wherein at least one end of the capillary is flame sealed.

25. The backlight unit apparatus in accordance with claim 1, wherein at least one end of the capillary is sealed with glass.

26. A liquid crystal display unit comprising a backlight unit apparatus in accordance with claim 1, and a liquid crystal display panel positioned to be in optical communication with white light emitted from the backlight unit apparatus.

27. A method of manufacturing a backlight unit apparatus in accordance with claim 1 or 2, comprising transferring a liquid mixture including quantum dots, the transferring a liquid mixture comprising contacting the capillary with a supply of the liquid mixture including quantum dots and increasing gas pressure on the surface of the liquid mixture including quantum dots such that the liquid mixture including quantum dots is forced into the vessel.

28. The method of claim 27, wherein the supply of the liquid mixture including quantum dots is present in a contained environment.

29. The method of claim 28, wherein gas pressure is increased within the contained environment by forcing gas from an external source into the contained environment.

30. The method of claim 27, wherein the capillary is substantially filled with the liquid mixture including quantum dots, removed and sealed.

## Patentansprüche

1. Hintergrundbeleuchtungsvorrichtung zur Erzeugung von weißem Licht, umfassend:
eine Lichtquelle, die in der Lage ist, blaues Licht abzugeben;
ein optisches Material, umfassend ein Host-Material und erste Quantenpunkte, die in der Lage sind, grünes Licht auszugeben, und zweite Quantenpunkte, die in der Lage sind, rotes Licht auszugeben, wobei das Gewichtsprozentverhältnis der ersten Quantenpunkte zu den zweiten Quantenpunkten im optischen Material in einem Bereich von 9:1 bis 2:1 liegt,
wobei die Lichtquelle positioniert ist, um in der Lage zu sein, das optische Material zu beleuchten, und wobei das optische Material angrenzend an eine Kantenfläche einer transparenten Lichtführung positioniert ist; und
**dadurch gekennzeichnet, dass** die Hintergrundbeleuchtungsvorrichtung ferner eine Optik umfasst, die eine transparente Kapillare, umfassend das optische Material, umfasst, wobei ein lichtreflektierendes Material die Kapillare teilweise umgibt.

2. Hintergrundbeleuchtungsvorrichtung nach Anspruch 1, wobei das blaue Licht der Lichtquelle eine mittlere Wellenlängenspitze im Bereich von 450 nm bis 460 nm aufweist und das optische Material erste Quantenpunkte, die in der Lage sind, grünes Licht mit einer mittleren Wellenlängenspitze in einem Bereich von 520 nm bis 540 nm auszugeben, und zweite Quantenpunkte, die in der Lage sind, rotes Licht mit einer mittleren Wellenlängenspitze in einem Bereich von 615 nm bis 630 nm auszugeben, umfasst.

3. Hintergrundbeleuchtungsvorrichtung nach Anspruch 1 oder 2, wobei die Gesamtkonzentration der ersten Quantenpunkte und der zweiten Quantenpunkte im optischen Material in einem Bereich vom 0,5 bis 10 Gewichtsprozent liegt.

4. Hintergrundbeleuchtungsvorrichtung nach Anspruch 1 oder 2, wobei das Verhältnis des Gewichtsprozents der ersten Quantenpunkte zum Gewichtsprozent der zweiten Quantenpunkte im optischen Material in einem Bereich von 6:1 bis 2:1, insbesondere in einem Bereich von 5:1 bis 3:1 liegt.

5. Hintergrundbeleuchtungsvorrichtung nach Anspruch 1 oder 2, wobei das optische Material ferner Streuelemente in einer Menge in einem Bereich von 0,1 bis 1 Gewichtsprozent enthält.

6. Hintergrundbeleuchtungsvorrichtung nach Anspruch 1 oder 2, wobei das Verhältnis der Intensität des blauen Lichts zum grünen Licht im weißen, von der Vorrichtung erzeugten Licht in einem Bereich von 0,75 bis 4 liegt und das Verhältnis der Intensität des grünen Lichts zum roten Licht im weißen, von der Vorrichtung erzeugten Licht in einem Bereich von 0,75 zu 2,0 liegt.

7. Hintergrundbeleuchtungsvorrichtung nach Anspruch 1 oder 2 oder Anspruch 6, wobei jede der roten und grünen Lichtkomponenten des weißen Lichts eine Strahlungsspitze mit einem FWHM in einem Bereich von 25 nm bis 50 nm aufweist.

8. Hintergrundbeleuchtungsvorrichtung nach Anspruch 1 oder 2, wobei die ersten Quantenpunkte und die zweiten Quantenpunkte homogen im gesamten Host-Material verteilt sind.

9. Hintergrundbeleuchtungsvorrichtung nach Anspruch 1, wobei das lichtreflektierende Material die Kapillare teilweise umgibt, so dass vom optischen Material in einer von der Kante der Lichtführung wegweisenden Richtung ausgegebenes Licht zur Kante der Lichtführung reflektiert wird.

10. Hintergrundbeleuchtungsvorrichtung nach Anspruch 9, wobei das lichtreflektierende Material einen Teil der oberen Oberfläche der Lichtführung kontaktiert, einen Teil des optischen Materials umgibt und einen Teil der unteren Oberfläche der Lichtführung umgibt, so dass vom optischen Material in einer von der Kante der Lichtführung wegweisenden Richtung ausgegebenes Licht zur Kante der Lichtführung reflektiert wird.

11. Hintergrundbeleuchtungsvorrichtung nach Anspruch 9 oder 10, wobei das lichtreflektierende Material eine Öffnung, angrenzend an die Lichtquelle enthält, so dass von der Lichtquelle ausgegebenes Licht in das optische Material eintreten kann.

12. Hintergrundbeleuchtungsvorrichtung nach Anspruch 9, wobei ein lichtreflektierendes Material einen Teil einer oberen Oberfläche der Lichtführung kontaktiert, die Lichtquelle und einen Teil des optischen Materials umgibt und einen Teil einer unteren Oberfläche der Lichtführung kontaktiert, so dass das vom optischen Material in einer von der Kante der Lichtführung wegweisenden Richtung ausgegebene Licht zur Kante der Lichtführung reflektiert wird.

13. Hintergrundbeleuchtungsvorrichtung nach Anspruch 1, 9 oder 10, wobei das lichtreflektierende Material einen Kurzpassfilter umfasst, der das Durchleiten von Licht von der Lichtquelle zulässt, während er Licht von den ersten Quantenpunkten und den zweiten Quantenpunkten reflektiert.

14. Hintergrundbeleuchtungsvorrichtung nach Anspruch 1, wobei das optische Material angrenzend an eine Flächenoberfläche der Lichtführung positioniert und in einer Folie enthalten ist.

15. Hintergrundbeleuchtungsvorrichtung nach Anspruch 13, wobei der Kurzpassfilter selektiv blaues Licht mit einer Wellenlänge in einem Bereich von 420 nm bis 480 nm übertragen und selektiv Licht mit einer Wellenlänge in einem Bereich von 481 nm bis 680 nm reflektieren kann.

16. Hintergrundbeleuchtungsvorrichtung nach Anspruch 1, wobei eine Oberfläche entlang der Länge der Kapillare frei von lichtreflektierendem Material ist, insbesondere am nächsten zur Lichtführung.

17. Hintergrundbeleuchtungsvorrichtung nach Anspruch 15, wobei die Übertragung des Kurzpassfilters im Bereich von 420 nm bis 480 nm mindestens 90 % beträgt.

18. Hintergrundbeleuchtungsvorrichtung nach Anspruch 15 oder 17, wobei die Übertragung des Kurzpassfilters im Bereich von 481 nm bis 680 nm höchstens 5% beträgt.

19. Hintergrundbeleuchtungsvorrichtung nach Anspruch 1 oder 9, wobei die Kapillare mindestens eines der Folgenden aufweist:
einen kreisförmigen Querschnitt,
einen tetragonalen Querschnitt,
einen quadratischen Querschnitt,
einen rechtwinkligen Querschnitt und
einen trapezoiden Querschnitt.

20. Hintergrundbeleuchtungsvorrichtung nach Anspruch 19, wobei in dem Fall, dass die Kapillare einen tetragonalen Querschnitt aufweist, das lichtreflektierende Material auf einer Oberfläche der Kapillare am nächsten der Lichtquelle beschichtet ist, insbesondere auf der oberen und unteren Oberfläche einer Oberfläche der Kapillare.

21. Hintergrundbeleuchtungsvorrichtung nach Anspruch 1 oder 9, wobei die Enden der Kapillare mit einem Material beschichtet sind, um zu verhindern, dass aus den Enden davon Licht ausgegeben wird.

22. Hintergrundbeleuchtungsvorrichtung nach Anspruch 1, wobei das lichtreflektierende Material auf einem Teil der Oberfläche entlang der Länge der Kapillare gegenüber der von lichtreflektierendem Material freien Oberfläche beschichtet ist, und
wobei die Oberfläche mit einer vorgegebenen Anordnung von einer oder mehreren vordefinierten Flächen, die zur Positionierung einer Lichtquelle auf jeder der vordefinierten Flächen unbeschichtet sind, mit lichtreflektierendem Material beschichtet ist, so dass von der Lichtquelle ausgegebenes Licht in das optische Material eintreten kann.

23. Hintergrundbeleuchtungsvorrichtung nach Anspruch 1, wobei das optische Material einen EQE von mindestens 70 % aufweist.

24. Hintergrundbeleuchtungsvorrichtung nach Anspruch 1, wobei mindestens ein Ende der Kapillare feuerversiegelt ist.

25. Hintergrundbeleuchtungsvorrichtung nach Anspruch 1, wobei mindestens ein Ende der Kapillare mit Glas versiegelt ist.

26. Flüssigkristallanzeigeeinheit, umfassend eine Hintergrundbeleuchtungsvorrichtung nach Anspruch 1, und ein Flüssigkristallanzeigefeld, das zur optischen Kommunikation mit von der Hintergrundbeleuchtungsvorrichtung ausgegebenem weißem Licht positioniert ist.

27. Verfahren zum Herstellen einer Hintergrundbeleuchtungsvorrichtung nach Anspruch 1 oder 2, umfassend das Übertragen einer flüssigen Mischung, enthaltend Quantenpunkte, wobei das Übertragen einer flüssigen Mischung das Kontaktieren der Kapillare mit einer Zufuhr der flüssigen Mischung, enthaltend Quantenpunkte, und das Erhöhen des Gasdrucks auf die Oberfläche der flüssigen Mischung, enthaltend Quantenpunkte, umfasst, so dass die flüssige Mischung, enthaltend Quantenpunkte, in den Behälter gezwungen wird.

28. Verfahren nach Anspruch 27, wobei die Zufuhr der flüssigen Mischung, enthaltend Quantenpunkte, in einer abgeschlossenen Umgebung vorhanden ist.

29. Verfahren nach Anspruch 28, wobei der Gasdruck in der umschlossenen Umgebung erhöht wird, indem Gas von einer externen Quelle in die umschlossene Umgebung gezwungen wird.

30. Verfahren nach Anspruch 27, wobei die Kapillare im Wesentlichen mit der flüssigen Mischung, enthaltend Quantenpunkte, gefüllt, entfernt und gedichtet wird.

## Revendications

1. Appareil de rétroéclairage pour générer une lumière blanche, comprenant :
une source lumineuse capable d'émettre une lumière bleue ;
un matériau optique comprenant un matériau hôte et des premiers points quantiques capable d'émettre une lumière verte et des deuxièmes points quantiques capables d'émettre une lumière rouge, dans lequel le rapport en pourcentage de poids des premiers points quantiques aux deuxièmes points quantiques dans le matériau optique est dans la gamme de 9:1 à 2:1 ;
dans lequel la source lumineuse est positionnée de manière à pouvoir éclairer le matériau optique et dans lequel le matériau optique est positionné de manière adjacente à une surface de bord d'un guide de lumière transparent ; et
**caractérisé en ce que** l'appareil de rétroéclairage comprend en outre un dispositif optique comprenant un capillaire transparent comprenant le matériau optique, dans lequel un matériau réfléchissant la lumière entoure partiellement le capillaire.

2. Appareil de rétroéclairage selon la revendication 1, dans lequel la lumière bleue de la source lumineuse a une longueur d'onde centrale maximale dans une gamme de 450 nm à 460 nm et le matériau optique comprend des premiers points quantiques capables d'émettre une lumière verte ayant une longueur d'onde centrale maximale dans une gamme de 520 nm à 540 nm et des deuxièmes points quantiques capables d'émettre une lumière rouge ayant une longueur d'onde centrale maximale dans une gamme de 615 nm à 630 nm.

3. Appareil de rétroéclairage selon la revendication 1 ou 2, dans lequel la concentration totale de premiers points quantiques et de deuxièmes points quantiques dans le matériau optique est dans une gamme de 0,5 à 10 pour cent en poids.

4. Appareil de rétroéclairage selon la revendication 1 ou 2, dans lequel le rapport en pourcentage de poids des premiers points quantiques au pourcentage de poids des deuxièmes points quantiques dans le matériau optique est dans une gamme de 6:1 à 2:1, en particulier dans une gamme de 5:1 à 3:1.

5. Appareil de rétroéclairage selon la revendication 1 ou 2, dans lequel le matériau optique comprend en outre des diffuseurs à raison de 0,1 à 1 pour cent en poids.

6. Appareil de rétroéclairage selon la revendication 1 ou 2, dans lequel le rapport d'intensité de la lumière bleue à la lumière verte dans la lumière blanche générée par l'appareil est dans la gamme de 0,75 à 4 et le rapport d'intensité de la lumière verte à la lumière rouge dans la lumière blanche générée par l'appareil est dans une gamme de 0,75 à 2,0.

7. Appareil de rétroéclairage selon la revendication 1 ou 2 ou la revendication 6, dans lequel chacune des composantes de lumière rouge et verte de la lumière blanche a une émission de pointe ayant une LTMH dans une gamme de 25 nm à 50 nm.

8. Appareil de rétroéclairage selon la revendication 1 ou 2, dans lequel les premiers points quantiques et les deuxièmes points quantiques sont répartis de façon homogène dans tout le matériau hôte.

9. Appareil de rétroéclairage selon la revendication 1, dans lequel le matériau réfléchissant la lumière entoure partiellement le capillaire de telle sorte que la lumière émise par le matériau optique dans une direction s'éloignant du bord du guide de lumière est réfléchie vers le bord du guide de lumière.

10. Appareil de rétroéclairage selon la revendication 9, dans lequel le matériau réfléchissant la lumière entre en contact avec une partie d'une surface supérieure du guide de lumière, entoure une partie du matériau optique et entre en contact avec une partie d'une surface inférieure du guide de lumière de sorte que la lumière émise par le matériau optique dans une direction s'éloignant du bord du guide de lumière est réfléchie vers le bord du guide de lumière.

11. Appareil de rétroéclairage selon la revendication 9 ou 10, dans lequel le matériau réfléchissant la lumière comporte une ouverture adjacente à la source lumineuse de telle sorte que la lumière émise par la source lumineuse peut entrer dans le matériau optique.

12. Appareil de rétroéclairage selon la revendication 9, dans lequel un matériau réfléchissant la lumière entre en contact avec une partie d'une surface supérieure du guide de lumière, entoure la source lumineuse et une partie du matériau optique et entre en contact avec une partie d'une surface inférieure du guide de lumière, de sorte que la lumière émise par le matériau optique dans une direction s'éloignant du bord du guide de lumière est réfléchie vers le bord du guide de lumière.

13. Appareil de rétroéclairage selon la revendication 1, 9 ou 10, dans laquelle le matériau réfléchissant la lumière comprend un filtre passe-bande courte permettant à la lumière de la source lumineuse de passer au travers tout en réfléchissant la lumière des premiers points quantiques et des deuxièmes points quantiques.

14. Appareil de rétroéclairage selon la revendication 1, dans lequel le matériau optique est positionné de manière adjacente à une surface de face du guide de lumière et inclus dans un film.

15. Appareil de rétroéclairage selon la revendication 13, dans lequel le filtre passe-bande courte peut transmettre sélectivement une lumière bleue ayant une longueur d'onde dans une gamme de 420 nm à 480 nm et peut réfléchir sélectivement la lumière ayant une longueur d'onde dans une gamme de 481 nm à 680 nm.

16. Appareil de rétroéclairage selon la revendication 1, dans lequel une surface sur la longueur du capillaire est exempte de matériau réfléchissant la lumière, en particulier le plus près du guide de lumière.

17. Appareil de rétroéclairage selon la revendication 15, dans lequel la transmission du filtre passe-bande courte dans la gamme de 420 nm à 480 nm est d'au moins 90 %.

18. Appareil de rétroéclairage selon la revendication 15 ou 17, dans lequel la transmission du filtre passe-bande courte dans la gamme de 481 nm à 680 nm n'est pas supérieure à 5 %.

19. Appareil de rétroéclairage selon la revendication 1 ou 9, dans lequel le capillaire a au moins l'une des sections suivantes :
une section transversale circulaire,
une section transversale tétragonale,
une section transversale carrée,
une section transversale rectangulaire, et
une section transversale trapézoïdale.

20. Appareil de rétroéclairage selon la revendication 19, dans lequel, dans le cas où le capillaire a une section transversale tétragonale, le matériau réfléchissant la lumière est revêtu sur une surface du capillaire la plus proche de la source lumineuse, en particulier sur les surfaces supérieure et inférieure d'une surface du capillaire.

21. Appareil de rétroéclairage selon la revendication 1 ou 9, dans lequel les extrémités du capillaire sont revêtues d'un matériau pour empêcher l'émission de lumière par ses extrémités.

22. Appareil de rétroéclairage selon la revendication 1, dans lequel le matériau réfléchissant la lumière est revêtu sur une partie de la surface sur la longueur du capillaire opposée à la surface exempte de matériau réfléchissant la lumière, et
dans lequel la surface est revêtue de matériau réfléchissant la lumière, avec un agencement prédéterminé d'une ou plusieurs zones prédéfinies non revêtues pour la mise en place d'une source lumineuse à chaque zone prédéfinie de sorte que la lumière émise par la source lumineuse puisse entrer dans le matériau optique.

23. Appareil de rétroéclairage selon la revendication 1, dans lequel le matériau optique a une EQE d'au moins 70%.

24. Appareil de rétroéclairage selon la revendication 1, dans lequel au moins une extrémité du capillaire est scellée à la flamme.

25. Appareil de rétroéclairage selon la revendication 1, dans lequel au moins une extrémité du capillaire est scellée par du verre.

26. Dispositif d'affichage à cristaux liquides comprenant un appareil de rétroéclairage selon la revendication 1 et un panneau d'affichage à cristaux liquides positionné pour être en communication optique avec la lumière blanche émise par l'appareil de rétroéclairage.

27. Procédé de fabrication d'un appareil de rétroéclairage selon la revendication 1 ou 2, comprenant le transfert d'un mélange liquide comportant des points quantiques, le transfert d'un mélange liquide comprenant la mise en contact du capillaire avec une alimentation en mélange liquide comportant des points quantiques et l'augmentation de la pression de gaz sur la surface du mélange liquide comportant des points quantiques de sorte que le mélange liquide comportant des points quantiques est introduit de force dans le récipient.

28. Procédé selon la revendication 27, dans lequel l'alimentation en mélange liquide comportant des points quantiques est présente dans un milieu confiné.

29. Procédé selon la revendication 28, dans lequel la pression de gaz est augmentée à l'intérieur du milieu confiné par introduction forcée de gaz d'une source extérieure dans le milieu confiné.

30. Procédé selon la revendication 27, dans lequel le capillaire est essentiellement rempli du mélange liquide comportant des points quantiques, enlevé et scellé.
